(19) Europäisches Patentamt
European Patent Office
Office européen des brevets

(11) EP 1 834 969 A2

(12) **EUROPEAN PATENT APPLICATION**

(43) Date of publication:
**19.09.2007 Bulletin 2007/38**

(21) Application number: **07004682.6**

(22) Date of filing: **07.03.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK YU**

(30) Priority: **07.03.2006 US 369429**

(51) Int Cl.:
***C08F 220/18*** (2006.01) ***C08L 33/06*** (2006.01)

(71) Applicant: **National Starch and Chemical Investment Holding Corporation**
**New Castle,**
**Delaware 19720 (US)**

(72) Inventors:
- **Osama, M. Musa**
**Hillsborough**
**New Jersey 08844 (US)**
- **Ruzhi, Zhang**
**Pennington**
**New Jersey 08534 (US)**
- **Becker, Kevin**
**Cerritos**
**California 90703 (US)**
- **Zannoni, Luke**
**High Bridge**
**New Jersey 08829 (US)**

(74) Representative: **Held, Stephan et al**
**Meissner, Bolte & Partner GbR**
**Postfach 86 03 29**
**81630 München (DE)**

## (54) Curable materials containing siloxane

(57) A polymer is prepared from monomers containing at least one carbon to carbon double bond and at least one siloxane moiety and from monomers containing at least one carbon to carbon double bond and at least one moiety that imparts reactivity to the resulting polymer. Siloxane moieties impart permeability; reactivity is obtained from monomers containing epoxy, oxetane, oxazoline, benzoxazine, or episulfide functionality. Additional properties can be added to the polymer by the Inclusion in the initial polymerization mix of monomers that impart low glass transition temperature, high glass transition temperature, and adhesion. The level of each functionality can be controlled by the practitioner by varying the amount of monomer containing that functionality added to the initial polymerization. These materials can be B-staged.

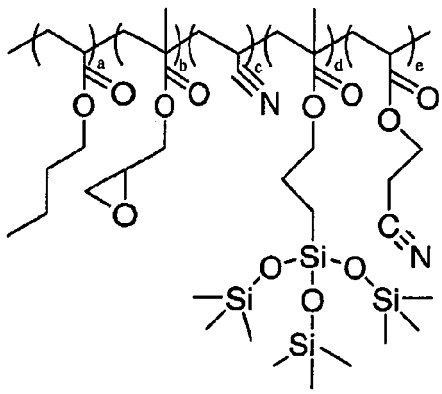

EP 1 834 969 A2

## Description

FIELD OF THE INVENTION

This invention relates to materials containing siloxanes and reactive moieties that are capable of reacting to form a new covalent bond.

BACKGROUND OF THE INVENTION

In the fabrication of articles of manufacture, adhesives and coatings may be applied to one or more surfaces of the article or to the substrate for the article, and the article or substrate held for finishing steps at a later time. Typically the adhesive or coating is in paste form, prepared from a solid resin and a solvent or from a sufficiently viscous liquid resin. If the starting material is a blend of solid and solvent, after application to the substrate or the article, the material is heated to evaporate the solvent, leaving a solidified, although typically still uncured, adhesive or coating material. If the starting material is a liquid or semi-liquid, it is dispensed neat onto the article or substrate and heated or irradiated to partially cure to a solidified state. The evaporation of the solvent or the partial cure accomplished by the application of heat or irradiation at this stage in fabrication is termed B-staging, and the adhesive or coating, B-stageable.

B-staged materials can be too tacky for successful storage. Tackiness typically is caused by low molecular weight polymers and can be corrected by using high molecular weight polymers. B-staged materials also are prone to absorbing moisture. At elevated temperatures, the absorbed moisture will evaporate rapidly, and if this evaporation occurs faster than the vapors can diffuse out of the material, voids or bubbles are created. These can be a source of ultimate failure of the adhesive or coating. Voiding can be corrected by utilizing polymers with high permeability. The combined requirements of low tackiness and low voiding can be met with high molecular weight polymers with high permeability. When high molecular weight polymers are used to correct for tackiness and voiding, the processing becomes more difficult because of increased viscosity, and consequently, printability, flow, and wet-out of the material are compromised. Thus; there is a need for materials that cause neither voids, nor tackiness, nor unsuitably high viscosity.

SUMMARY OF THE INVENTION

This invention is a polymer comprising a backbone and pendant from the backbone at least one siloxane moiety, and at least one reactive moiety capable of reacting to form a new covalent bond. The polymer is prepared by the reaction of one or more monomers that contain at least one carbon to carbon double bond and the at least one siloxane moiety, and one or more monomers that contain at least one carbon to carbon double bond and the at least one reactive moiety capable of reacting to form a new covalent bond. In a further embodiment the polymeric backbone will contain one or more moieties that impart low glass transition temperature (Tg), high glass transition temperature, adhesion, permeability, or any combination of these properties. The moieties will be present in random order on the polymer backbone and at a level as determined by the practitioner by varying the amount of monomer containing that functionality that is used in the polymerization. These materials can be B-staged.

The structure and composition of the backbone of the polymer and the organic moieties linking the backbone with the pendant functionality will be dependent on the monomers used to synthesize the polymer. In general, the monomers will contain a carbon to carbon double bond and a functionality to impart one or more of the properties recited above. The carbon to carbon double bonds from the various monomers will react to form the polymer backbone. The functionalities that impart the properties of (i) permeability, (ii) low glass transition temperature (Tg), (iii) high glass transition temperature, (iv) reactivity to form a new covalent bond, and (v) adhesion, should be chosen so that they do not react in the initial polymerization reaction. Suitable monomers containing carbon to carbon double bonds include, but are not limited to, acrylate, methacrylate, fumarate, maleate, maleimide, vinyl ether, allyl ether, propargyl ether, acrylamide, styrenic, and cinnamyl compounds. Compounds such as these containing carbon to carbon double bonds will further contain functionality to impart a desired property.

The high permeability property is provided by the reaction of siloxane monomers into the polymerization mix. When siloxane is added to the polymer, the polymer shows a reduction in voiding compared to a similar polymer without siloxane and shows reduced tackiness after B-staging.

The polymer can be prepared so that its curing event will occur separately from the initial polymerization of monomers that produces the polymer itself. This is accomplished by utilizing polymerization technology that results in, or by reacting in monomers that contain, a reactive functionality curable by heat or irradiation, separate from the carbon to carbon double bond. The polymer possesses low viscosity, which is desirable in B-stageable adhesives due to processing requirements during manufacture and dispensing and printing requirements during application to substrates. Processing can be accomplished either by mixing or dissolving in an organic solvent and/or other resins, and with accelerators and additives. In another embodiment, this invention is a curable composition comprising the polymer as described above and, optionally, one or more other curable resins, optionally, one or more curing agents, and optionally, one or more fillers.

In another embodiment, this invention is an article having deposited thereon a polymer or a curable composition containing the polymer as described herein. In another embodiment, this invention is an article having deposited thereon a polymer or a curable composition containing the polymer as described herein, which polymer or composition has been

heated or irradiated to B-stage.

In another embodiment, this invention is a substrate for a semiconductor wafer or chip, or a semiconductor wafer or chip, having deposited thereon a polymer or a curable composition containing the polymer as described herein. In another embodiment, this invention is a substrate for a semiconductor wafer or chip, or a semiconductor wafer or chip, having deposited thereon a polymer or a curable composition containing the polymer as described herein, which polymer or composition has been heated or irradiated to B-stage.

In another embodiment, this invention is a semiconductor package or assembly, having deposited thereon a polymer or a curable composition containing the polymer as described herein. In another embodiment, this invention is a semiconductor package or assembly, having deposited thereon a polymer or the curable composition containing the polymer as described herein, which polymer or composition has been heated or irradiated to B-stage.

DETAILED DESCRIPTION OF THE INVENTION

The polymer materials of this invention are prepared from the reaction of monomers having the properties enumerated above. The exact composition or structure of the backbone of the polymer is not critical and will depend on the specific monomers chosen for the polymerization mix. The exact levels of functionality of low Tg, high Tg, reactivity, permeability, and adhesion, are not critical and can be tuned by the practitioner by the amount of monomer containing that functionality that is added to the monomer mix in the preparation of the polymer. These polymer materials may be elastomeric.

The high permeability property is provided by one or more siloxane monomers containing siloxane functionality and at least one carbon to carbon double bond. These monomers will be present in the resulting polymers within the range of 0.01 to 97% by weight. Exemplary monomers include, but are not limited to, the group consisting of

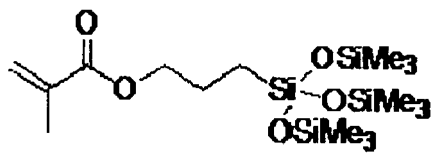

and

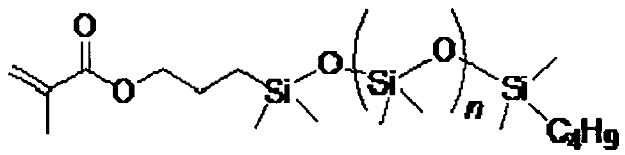

in which n is an integer from 1 to 100 and both of these.

Permeability is defined as the movement of a permeant through a material. In this invention, permeability refers to the movement of water molecules through a polymeric material. A material's permeability is expressed in terms of a permeability coefficient (P), defined as:

$$P = \frac{(\text{quantity of permeant})x(\text{film thickness})}{(\text{area})x(\text{time})x(\text{permeant concentration change across the film})}$$

More often, the permeation coefficient is used as it is more easily measured:

$$\text{permeation coefficient} = \frac{(\text{quantity of permeant})x(\text{film thickness})}{(\text{area})x(\text{time})}$$

In these equations "film" can refer to either the B-staged or cured material. In order to relate the permeation

coefficient to the permeability coefficient (P), the temperature, pressure, and relative humidity must be documented and kept constant. By conducting all measurements at the same relative humidity, temperature, and pressure the permeation coefficients of different materials can be compared and will relate to the inherent permeability of the materials. In the examples in this specification, the permeation coefficient is used to compare permeability.

Monomers that will impart a high Tg (above about 0ºC) property to the resulting polymer include, but are not limited to, the group consisting of methyl acrylate, ethyl acrylate, isobutyl methacrylate, vinyl acetate, methyl methacrylate, isobutyl methacrylate, vinyl pyrrolidone, vinyl formamide, acrylonitrile, substituted acrylamides or methacrylamides, and combinations of those.

Monomers that will impart a low Tg (less than about 0ºC) property to the resulting polymer include, but are not limited to, the group consisting of alkyl acrylates having up to about 18 carbon atoms in the alkyl group, preferably from about four to about ten carbon atoms in the alkyl group, and include n-butyl acrylate, amyl acrylate, hexyl acrylate, 2-ethylhexyl acrylate, isooctyl acrylate, decyl acrylate, dodecyl acrylates, isomers thereof, and combinations thereof.

Monomers that will impart reactive (curable) functionality to the polymer include any containing both a reactive carbon to carbon double bond and a curable functionality other than a carbon to carbon double bond. Exemplary other functionalities include, but are not limited to, epoxy, oxetane, oxazoline, benzoxazine, or episulfide functionality. Representative compounds include, but are not limited to, the group consisting of

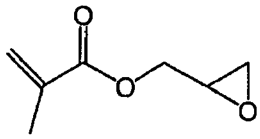
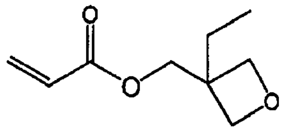

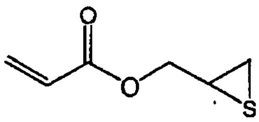
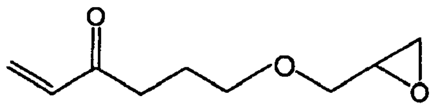

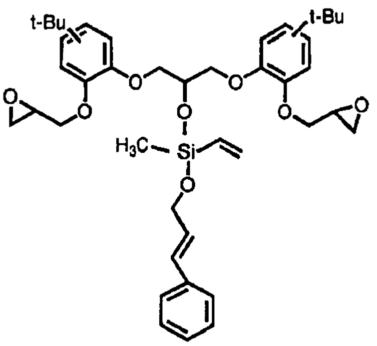
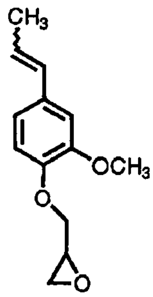

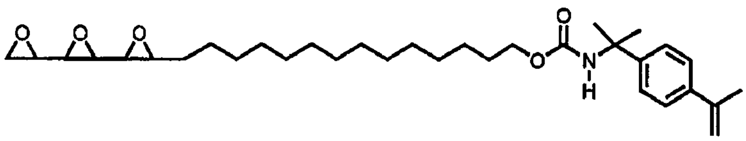

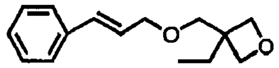

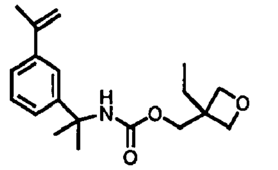

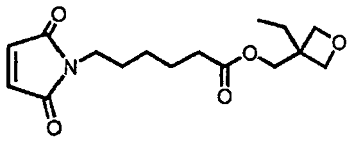

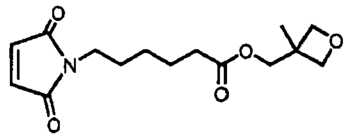

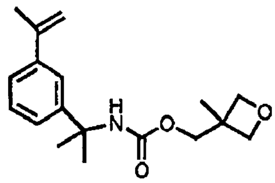

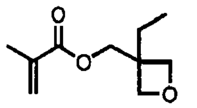

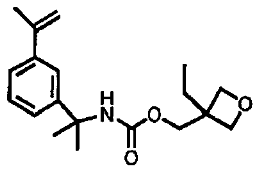

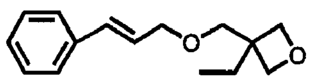

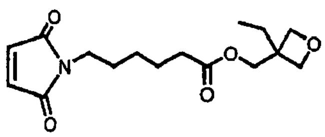

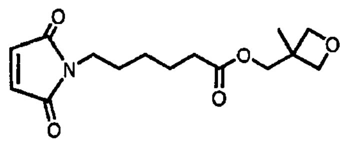

and

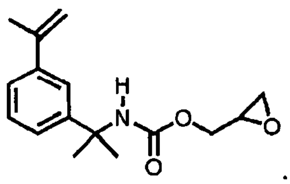

Synthetic methods for making these compounds are disclosed, for example, in US patents 6,441,121, 6,706,835, 6,953,862, 6,753,434, 6,982,338, and US patent publication 2004/0225074A1.

Monomers that impart adhesion to the polymer include, but are not limited to, the group consisting of

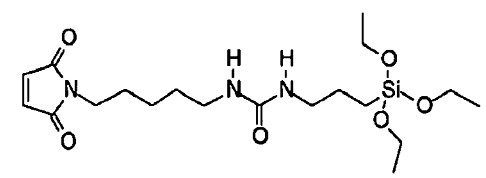

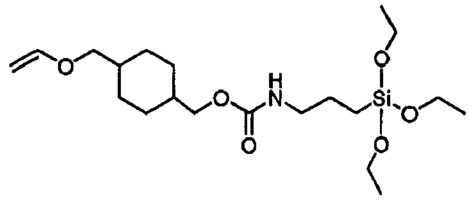

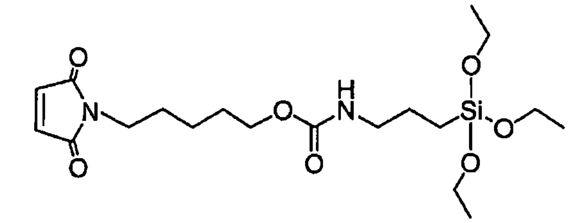

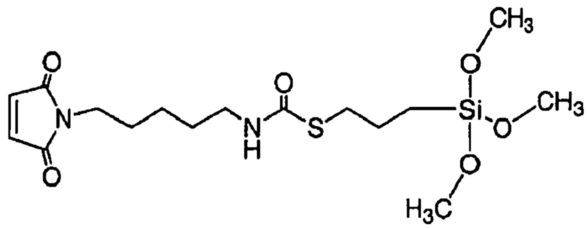

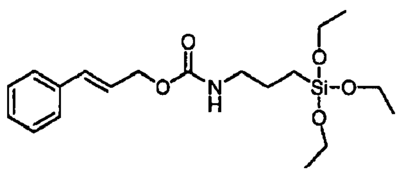

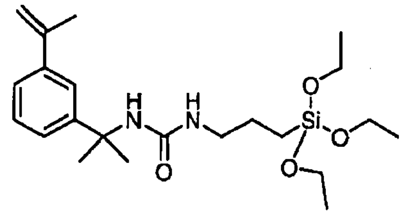

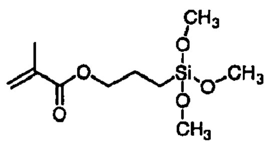

and compounds having the generic structures:

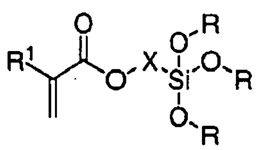

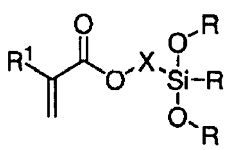

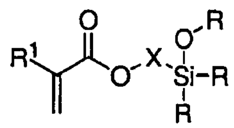

in which R is alkyl or aryl; $R^1$ is hydrogen, alkyl, or aryl; and X is an organic moiety. A representative compound is:

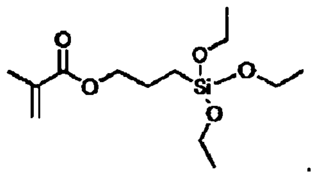

Synthetic methods for making these compounds can be found, for example, in US patent 6,441,213. Additional monomers for promoting adhesion include

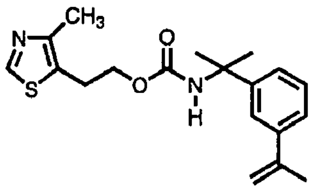

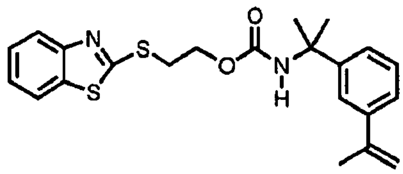

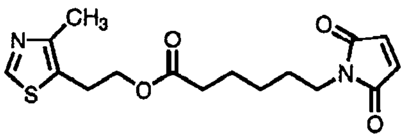

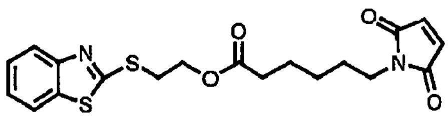

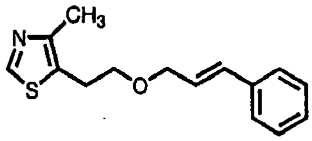

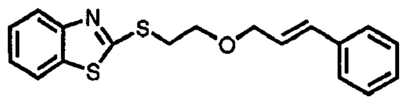

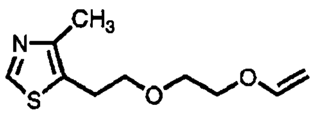

and

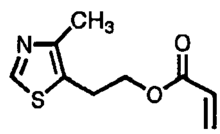

In addition to the monomers that will provide the functionalities specified, other reactive monomers that contain a reactive carbon to carbon double bond without any additional functionality may be added to the polymerization mix. Exemplary reactive monomers include but are not limited to acrylate, maleate, fumarate, maleimide, acrylamide, styrenic, cinnamyl, vinyl ether, allyl ether, and propargyl ether compounds.

The acrylic monomers include but are not limited to alpha, beta-unsaturated mono- and dicarboxylic acids having three to five carbon atoms, acrylate ester monomers selected from the group consisting of the alkyl esters of acrylic and methacrylic acid in which the alkyl groups contain four to twenty carbon atoms, preferably four to eight carbon atoms, such as, n-ethyl acrylate, n-butyl acrylate, n-pentyl acrylate, n-hexyl acrylate, n-heptyl acrylate, n-octyl acrylate, n-nonyl acrylate, phenyl methacrylate, and their corresponding branched isomers, such as, 2-ethylhexyl acrylate.

In addition, functionalized alkyl esters of acrylic or methacrylic acids can be used. Representative functional monomers include but are not limited to beta-carboxyethyl (meth)acrylate, 2-hydroxyethyl (meth)acrylate, 3-hydroxylpropryl (meth)acrylate, polyethoxy (meth)-acrylate, methoxypolyethoxy (meth)acrylate, dimethylaminoneopentyl (meth) acrylate, N-acryloyl sarcosine methyl ester, phenylthioethyl (meth)acrylate, 2-cyanoethyl acrylate, propargyl acrylate, trifluoroethyl (meth)acrylate, methacrylated polystyrene.

Vinyl monomers may be used in combination with the acrylic monomers and include vinyl monomers selected from the groups consisting of vinyl esters, vinyl ethers, vinyl halides, vinylidene halides, vinyl pyrrolidinone, maleimides, fumarates, maleates, itaconates, itaconimides, nadimides, and nitriles of ethylenically unsaturated hydrocarbons. Specific suitable vinyl monomers include but are not limited to vinyl acetate, acrylamide, t-octyl acrylamide, acrylic acid, vinyl ethyl ether, vinyl chloride, vinylidene chloride, acrylonitrile, maleic anhydride, styrene, vinyl pyrrolidone, and vinyl formamide.

The exact relative amounts of the specific components making up the polymer are dependent upon the final properties desired and are within the expertise of one skilled in the art without undue experimentation. The preparation of the polymer can be carried out using well-known polymerization procedures, such as free radial, anionic, and cationic techniques, using solution, emulsion, or bulk polymerization procedures. The polymer is formed into a material by removal of the solvent, coagulation of the latex, or melt-processing of the neat polymer. Exemplary processes are disclosed In the Examples section of this specification.

The polymer may be used as a component in a curable composition that may further comprise one or more other curable resins, one or more curing agents, or one or more fillers, or any combination of these. The composition may also contain additional additives selected by the practitioner to give suitable manufacturing and end use performance, such as adhesion promoters, fluxing agents, anti foaming agents, and solvents.

Suitable resins for the composition include, but are not limited to, epoxy, polyamide, phenoxy, polybenzoxazine, acrylate, cyanate ester, bismaleimide, polyether sulfone, polyimide, benzoxazine, vinyl ether, siliconized olefin, polyolefin, polybenzoxyzole, polyester, polystyrene, polycarbonate, polypropylene, poly(vinyl chloride), polylsobutylene, polyacrylonitrile, poly(methyl methacrylate), poly(vinyl acetate), poly(2-vinylpyridine), cis-1,4-polyisoprene, 3,4-polychloroprene, vinyl copolymer, poly(ethylene oxide), poly(ethylene glycol), polyformaldehyde, polyacetaldehyde, poly(b-propiolacetone), poly(10-decanoate), poly(ethylene terephthalate), polycaprolactam, poly(11-undecanoamide), poly(m-phenyleneterephthalamide), poly(tetramethlyene-m-benzenesulfonamide), polyester polyarylate, poly(phenylene oxide), poly(phenylene sulfide), polysulfone, polyetherketone, polyetherimide, fluorinated polyimide, polyimide siloxane, polyisoindoloquinazolinedione, polythioetherimide, polyphenylquinoxaline, polyquinixalone, imide-aryl ether phenylquinoxaline copolymer, polyquinoxaline, polybenzimidazole, polybenzoxazole, polynorbornene, poly(arylene ethers), polysilane, parylene, benzocyclobutenes, hydroxy(benzoxazole) copolymer, poly(silarylene siloxanes), and polybenzimidazole.

Suitable cyanate ester resins include those having the generic structure

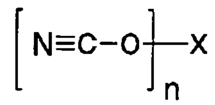

in which n is 1 or larger, and X is a hydrocarbon group. Exemplary X entities include, but are not limited to, bisphenol A, bisphenol F, bisphenol S, bisphenol E, bisphenol O, phenol or cresol novolac, dicyclopentadiene, polybutadiene, polycarbonate, polyurethane, polyether, or polyester. Commercially available cyanate ester materials include; AroCy L-10, AroCy XU366, AroCy XU371, AroCy XU378, XU71787.02L, and XU 71787.07L, available from Huntsman LLC; Primaset PT30, Primaset PT30 S75, Primaset PT60, Primaset PT60S, Primaset BADCY, Primaset DA230S, Primaset MethylCy, and Primaset LECY, available from Lonza Group Limited; 2-allyphenol cyanate ester, 4-methoxyphenol cyanate ester, 2,2-bis(4-cyanatophenol)-1,1,1,3,3,3-hexafluoropropane, bisphenol A cyanate ester, diallylbisphenol A cyanate ester, 4-phenylphenol cyanate ester, 1,1,1-tris(4-cyanatophenyl)ethane, 4-cumylphenol cyanate ester, 1,1-bis(4-cyanato-phenyl)ethane, 2,2,3,4,4,5,5,6,6,7,7-dodecafluorooctanediol dicyanate ester, and 4,4'-bisphenol cyanate ester, available from Oakwood Products, Inc.

Suitable epoxy resins include bisphenol, naphthalene, and aliphatic type epoxies. Commercially available materials include bisphenol type epoxy resins (Epiclon 830LVP, 830CRP, 835LV, 850CRP) available from Dainippon Ink & Chemicals, Inc.; naphthalene type epoxy (Epiclon HP4032) available from Dainippon Ink & Chemicals, Inc.; aliphatic epoxy resins (Araldite CY179, 184, 192,175,179) available from Ciba Specialty Chemicals, (Epoxy 1234, 249, 206) available from Dow, and (EHPE-3150) available from Daicel Chemical Industries, Ltd. Other suitable epoxy resins include cycloaliphatic epoxy resins, bisphenol-A type epoxy resins, bisphanol-F type epoxy resins, epoxy novolac resins, biphenyl type epoxy resins, naphthalene type epoxy resins, and dicyclopentadienephenol type epoxy resins.

Suitable maleimide resins include those having the generic structure

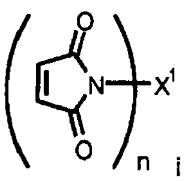

in which n is 1 to 3 and $X^1$ is an aliphatic or aromatic group. Exemplary $X^1$ entities include, poly(butadienes), poly (carbonates), poly(urethanes), poly(ethers), poly(esters), simple hydrocarbons, and hydrocarbons containing functionalities such as carbonyl, carboxyl, ester, amide, carbamate, urea, or ether. These types of resins are commercially available and can be obtained, for example, from Dainippon Ink and Chemical, Inc.

Additional suitable maleimide resins include, but are not limited to, solid aromatic bismaleimide resins, particularly those having the structure

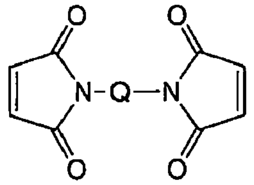

in which Q is an aromatic group; exemplary aromatic groups include:

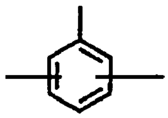
,
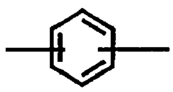
,
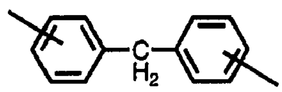
,

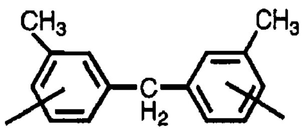
,
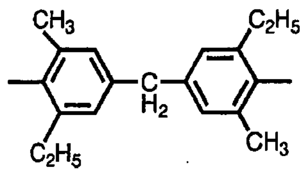
,

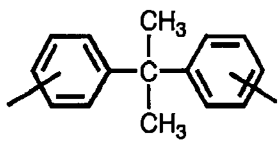
,
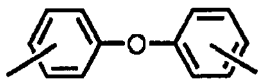

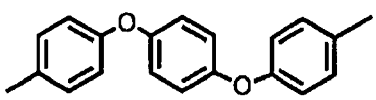
,
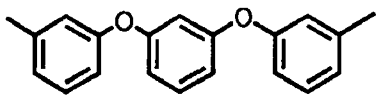

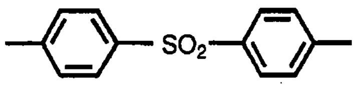
,

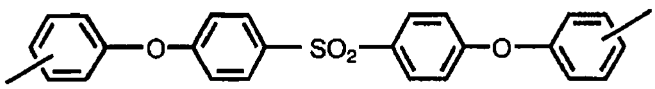

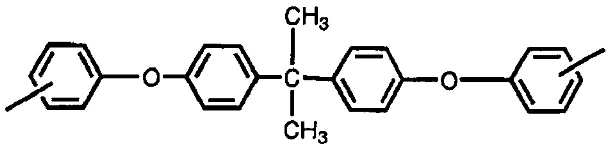

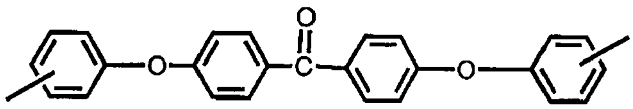

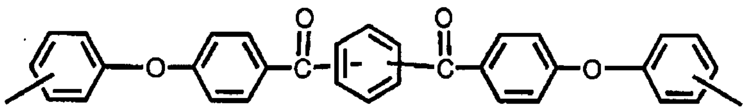

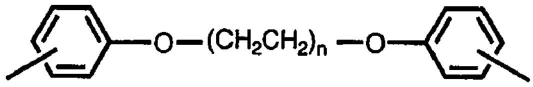

in which n is 1 - 3,

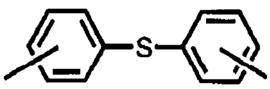 and 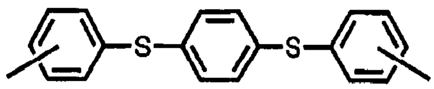.

Maleimide resins having these Q bridging groups are commercially available, and can be obtained, for example, from Sartomer (USA) or HOS-Technic GmbH (Austria).

Other suitable maleimide resins include the following:

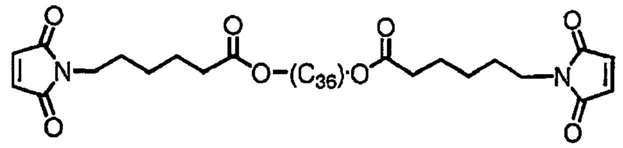

in which $C_{36}$ represents a linear or branched chain hydrocarbon chain(with or without cyclic moieties) of 36 carbon atoms;

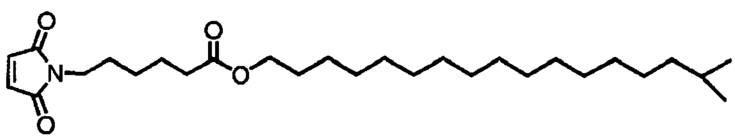

;

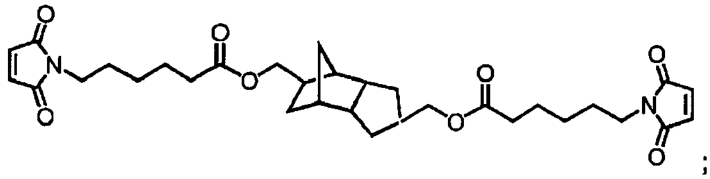

and

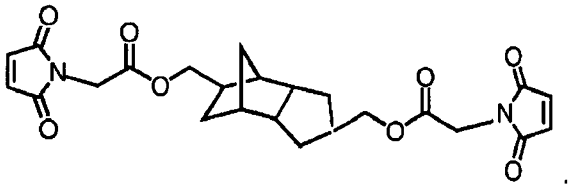

Suitable acrylate and methacrylate resins include those having the generic structure

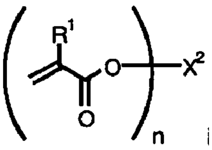

in which n is 1 to 6, $R^1$ is -H or $-CH_3$, and $X^2$ is an aromatic or aliphatic group. Exemplary $X^2$ entities include poly (butadienes), poly-(carbonates), poly(urethanes), poly(ethers), poly(esters), simple hydrocarbons, and simple hydrocarbons containing functionalities such as carbonyl, carboxyl, amide, carbamate, urea, or ether. Commercially available materials include butyl (meth)acrylate, isobutyl (meth)acrylate, 2-ethyl hexyl (meth)acrylate, isodecyl (meth)acrylate, n-lauryl (meth)acrylate, alkyl (meth)acrylate, tridecyl (meth)acrylate, n-stearyl (meth)acrylate, cyclohexyl(meth)acrylate, tetrahydrofurfuryl(meth)acrylate, 2-phenoxy ethyl(meth)acrylate, isobornyl(meth)acrylate, 1,4-butanediol di(meth)acrylate, 1.6 hexanediol di(meth)acrylate, 1,9-nonandiol di(meth)acrylate, perfluorooctylethyl (meth)acrylate, 1,10 decandiol di(meth)acrylate, nonylphenol polypropoxylate (meth)acrylate, and polypentoxylate tetrahydrofurfuryl acrylate, available from Kyoeisha Chemical Co., LTD; polybutadiene urethane dimethacrylate (CN302, NTX6513) and polybutadiene dimethacrylate (CN301, NTX6039, PRO6270) available from Sartomer Company, Inc; polycarbonate urethane diacrylate (ArtResin UN9200A) available from Negami Chemical Industries Co., LTD; acrylated aliphatic urethane oligomers (Ebecryl 230, 264, 265, 270,284, 4830, 4833, 4834, 4835, 4866, 4881, 4883, 8402, 8800-20R, 8803, 8804) available from Radcure Specialities, Inc; polyester acrylate oligomers (Ebecryl 657, 770, 810, 830, 1657, 1810, 1830) available from Radcure Specialities, Inc.; and epoxy acrylate resins (CN104, 111, 112, 115, 116, 117, 118, 119, 120, 124, 136) available from Sartomer Company, Inc. In one embodiment the acrylate resins are selected from the group consisting of isobornyl acrylate, isobornyl methacrylate, lauryl acrylate, lauryl methacrylate, poly(butadiene) with acrylate functionality and poly (butadiene) with methacrylate functionality.

Suitable vinyl ether resins are any containing vinyl ether functionality and include poly(butadienes), poly(carbonates), poly(urethanes), poly(ethers), poly(esters), simple hydrocarbons, and simple hydrocarbons containing functionalities such as carbonyl, carboxyl, amide, carbamate, urea, or ether. Commercially available resins include cyclohenanedimethanol divinylether, dodecylvinylether, cyclohexyl vinylether, 2-ethylhexyl vinylether, dipropyleneglycol divinylether, hexanediol divinylether, octadecylvinylether, and butandiol divinylether available from International Speciality Products (ISP); Vectomer 4010, 4020, 4030, 4040, 4051, 4210, 4220, 4230, 4060, 5015 available from Sigma-Aldrich, Inc.

The curing agent can be a catalyst, accelerator, initiator, or any combination of those. Selection of an appropriate curing agent is well within the expertise of one skilled in the art. Depending on the actual resin or combination of resins used in the composition, the curing agent can be, but is not limited to, one or more of the following: amines, triazines, metal salts, aromatic hydroxyl compounds. Examples of curing agents include imidazoles, such as 2-methylimidazole, 2-undecylimidazole, 2-heptadecyl imidazole, 2-phenylimidazole, 2-ethyl 4-methyl-imidazole, 1-benzyl-2-methylimidazole, 1-propyl-2-methylimidazole, 1-cyano-ethyl-2-methylimidazole, 1-cyanoethyl-2-ethyl-4-methylimidazole, 1-cyanoethyl-2-undecylimidazole, 1-cyanoethyl-2-phenylimidazole, 1-guanaminoethyl-2-methylimidazole and addition product of an imidazole and trimellitic acid; tertiary amines, such as N,N-dimethyl benzylamine, N,N-dimethylaniline, N,N-dimethyltoluidine, N,N-dimethyl-p-anisidine, p-halogeno-N,N-dimethylaniline, 2-N-ethylanilino ethanol, tri-n-butylamine, pyridine, quinoline, N-methylmorpholine, triethanolamine, triethylenediamine, N,N,N',N'-tetramethylbutanediamine, N-methylpiperidine; phenols, such as phenol, cresol, xylenol, resorcine, phenol novolac, and phloroglucin ; organic metal salts, such as lead naphthenate, lead stearate, zinc naphthenate, zinc octolate, tin oleate, dibutyl tin maleate, manganese naphthenate, cobalt naphthenate, and acetyl aceton iron; other metal compounds, such as, metal acetoacetonates, metal octoates, metal acetates, metal halides, metal imidazole complexes, Co(II)(acetoacetonate), Cu(II)(acetoacetonate), Mn(II)(acetoacetonate), Ti(acetoacetonate), and Fe(II)(acetoacetonate); and amine complexes; inorganic metal salts, such as stannic chloride, zinc chloride and aluminum chloride; peroxides, such as benzoyl peroxide, lauroyl peroxide, octanoyl peroxide, butyl peroctoate, dicumyl peroxide, acetyl peroxide, para-chlorobenzoyl peroxide and di-t-butyl diperphthalate; acid anhydrides, such as maleic anhydride, phthalic anhydride, lauric anhydride, pyromellitic anhydride, trimellitic anhydride, hexahydrophthalic anhydride; hexahydropyromellitic anhydride and hexahydrotrimellitic anhydride, azo compounds, such as azoisobutylonitrile, 2,2'-azobispropane, m,m'-azoxystyrene, hydrozones; adipic dihydrazide, diallyl melamine, diamino malconnitrile, and BF3-amine complexes; and mixtures thereof.

The curing agent can be either a free radical Initiator or ionic Initiator (either cationic or anionic), depending on whether a radical or ionic curing resin is chosen, and will be present in an effective amount. For free radical curing agents, an effective amount typically is 0.1 to 10 percent by weight of the organic compounds (excluding any filler). Preferred free-radical initiators include peroxides, such as butyl peroctoates and dicumyl peroxide, and azo compounds, such as 2,2'-azobis(2-methyl-propanenitrile) and 2,2'-azobis(2-methyl-butanenitrile). For ionic curing agents or initiators, an effective amount typically is 0.1 to 10 percent by weight of the organic compounds (excluding any filler). Preferred cationic curing agents include dicyandiamide, phenol novolak, adipic dihydrazide, diallyl melamine, diamino malconitrile, BF3-amine complexes, amine salts and modified Imidazole compounds.

In some cases, it may be desirable to use more than one type of cure. For example, both cationic and free radical initiation may be desirable, in which case both free radical cure and ionic cure resins can be used in the composition. Such a composition would permit, for example, the curing process to be started by cationic initiation using UV irradiation, and in a later processing step, to be completed by free radical initiation upon the application of heat

In some cases, the cure rate can be optimized by the use of cure accelerators, for example in cyanate ester systems. Cure accelerators include, but are not limited to, metal napthenates, metal acetylacetonates (chelates), metal octoates, metal acetates, metal halides, metal imidazole complexes, metal amine complexes, triphenylphosphine, alkyl-substituted imidazoles, imidazolium salts, and onium borates.

When a curing step is utilized, the cure temperature will generally be within a range of 80°-250°C, and curing will be effected within a time period ranging from few seconds or up to 120 minutes, depending on the particular resin chemistry and curing agents chosen. The time and temperature curing profile for each composition will vary, and different compositions can be designed to provide the curing profile that will be suited to the particular industrial manufacturing process.

For some applications, one or more fillers or spacers, or both, may be added to the curable composition and usually are added for improved rheological properties, stress reduction, and bondline control. Examples of suitable nonconductive fillers include alumina, aluminum hydroxide, silica, vermiculite, mica, wollastonite, calcium carbonate, titania, sand, glass, barium sulfate, zirconium, carbon black, organic fillers, and organic polymers including but not limited to halogenated ethylene polymers, such as, tatrafluoroethylene, trifluoroethylene, vinylidene fluoride, vinyl fluoride, vinylidene chloride, and vinyl chloride. Examples of suitable conductive fillers include carbon black, graphite, gold, silver, copper, platinum, palladium, nickel, aluminum, silicon carbide, boron nitride, diamond, and alumina. The particles may be of any appropriate size ranging from nano size to several mm, depending on whether they are used as fillers or spacers (spacers typically being the larger size particles with more uniformity of size). The choice of such size for any particular end use is within the expertise of one skilled in the art. Filler may be present in any amount determined by the practitioner to be suitable for the chosen end use.

These polymers can be tailored to have functionality at the level and for the purpose desired by the practitioner and thus, they will have usage in a wide variety of applications. They can be used, for example, in coatings, paints, composites, encapsulants, adhesives, electronic and microelectronic applications, and indeed, in any application where elastomeric polymers, for example, carboxy-terminated butylnitrile rubbers (CTBN), or where hyperbranched dendritic polymers, are used. They can be designed to have low Tg and high molecular weight to reduce tackiness; to contain controlled molecular weight distribution to minimize decreases in adhesion; to be uv curable; to have selective permeability. They can be prepared by the use of controlled free radical polymerization techniques to make blocky polymers, thus allowing more control of morphology and phase behavior to improve toughening efficiency.

These polymers can be used to toughen or increase the thermal stability (without increasing viscosity) of a number of other materials, for example, cyanate esters, other siloxane polymers, blends of epoxy and acrylates, blends of epoxy and maleimides, flexible materials that must meet operation temperatures of greater than 150ºC for long times,

or in any applications where epoxy currently is used to toughen compositions. These materials can also be designed with monomers that prevent the Tg from shifting with thermal aging, that is, that provide Tg stability for better thermal shock stability.

These polymers are especially useful for electronic device construction, within the semiconductor packaging industry, particularly as die-attach adhesives, because they are thermally stable and can be loaded with conductive fillers without an inordinate increase in viscosity. Additional applications for these materials include no-flow and capillary underfills (good permeability and low viscosity); heat sink attach with conductive fillers; wafer backside coating; low surface energy applications, for example, through the use of pendant fluoropolymers or the use of saturated oligomeric elastomer ethylene/butylene hybrid liquid macromers; lid seals; microencapsulants; spin coatable coatings; compatibilizers for epoxy siloxane copolymers and blends of epoxy; adhesion promoters for metal substrates; compositions with high loads of conductive fillers, such as, for printing antennae; binders for inks or coatings; termination coatings for passive components; adhesive anti-bleed agents; imageable adhesives, such as, negative tone photoresists; and abrasion resistant coatings, for example, for potentiometers.

EXAMPLES. Examples 1-10 describe the preparation of the polymeric material with the general structure of

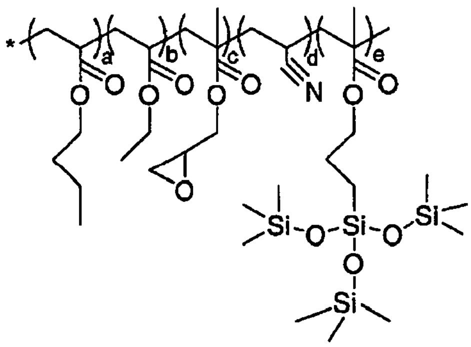

Example 2 describes the preparation of a comparison acrylic elastomer (i.e. when e=0%). Examples 4-6 describe the preparation of the polymer in various solvents. Examples 7-10 describe the preparation of the polymer with various molecular weight distributions. Examples 11-12 describe the preparation of the polymer with varying amounts of siloxane monomer (i.e. when e=5.0% and 2.5%). Examples 13-14 describe the preparation of the polymer with varying amounts of siloxane monomer (i.e when e=5.0% and 2.5%) and without ethyl acrylate (i.e. when b=0%). Examples 15-18 describe the preparation of the siloxane monomer with varying amounts of glycidyl methacrylate (i.e. when c=20%, 15%, 5%, and 2.5%) and without ethyl acrylate (i.e. when b=0%).

EXAMPLE 1: PREPARATION OF POLYMER AND PHYSICAL CHARACTERISTICS. A monomer mix of butyl acrylate (BA, 30 g), ethyl acrylate (EA, 30g), glycidyl methacrylate (GMA, 10 g), acrylonitrile (AN, 20 g), 3-(tris(trimethylsilyloxy)silyl)-propyl methacrylate (TMPS, 10g), and toluene (100 g) were charged into a 1L four-neck round bottom flask equipped with a thermometer, condenser, overhead stirrer, addition funnel, and nitrogen inlet/outlet. The mixture was purged with nitrogen for 30 minutes, then 2,2'-azobis(2-methylproplonitrile) (AIBN, 0.020g) as a free-radical initiator was charged into the flask, heated to 80°C in an oil bath and held at that temperature for 20 hours. The toluene was then removed to give 44.9 g of neat polymer, which was then dissolved in 50 g of carbitol acetate. The mixture was then washed with three 200 mL portions of methanol and dried in a vacuum oven at 80ºC overnight to yield a colorless rubber (20.29 g).

Mw was determined to be 147,823 g/mol by GPC. Polydispersity was approximately 1.7. The solids content was approximately 35%. The viscosity was 4164 cP at 50°C.

EXAMPLE 2, COMPARATIVE: PREPARATION OF AN ACRYLIC ELASTOMER AND PHYSICAL CHARACTERISTICS. A monomer mix of butyl acrylate (BA, 60g), ethyl acrylate (EA, 60g), glycidyl methacrylate (GMA, 20g), acrylonitrile (AN, 40g), and toluene (180 g) were charged into a 1 L four-neck round bottom flask equipped with a thermometer, condenser, overhead stirrer, addition funnel, and nitrogen Inlet/outlet. The mixture was purged with nitrogen for 30 minutes, then 2,2'-azobis(2-methylpropionitrile) (AIBN, 0.040g) as a free-radical initiator was charged into the flask, heated to 80°C in an oil bath, and held at that temperature for 20 h. Methanol (500 mL) was added to precipitate the polymer, then washed with two additional portions of methanol (100 mL). The polymer was dried in a vacuum oven at 80ºC overnight to give 11.4 g of rubber, which was dissolved in carbitol acetate to 47.65% solids.

Mw was determined to be 93,232 g/mol by GPC. Polydispersity was approximately 1.7. The viscosity was 7,796 cP at 50°C, considerably higher than that of Example 1.

Example 3: Preparation and Characterization of Poly(n-butyl acrylate-*co*-ethyl acrylate-*co*-glycidyl methacrylate-*co*-acrylonitrile-*co*-3-(tris(trimethylsilyoxy)silyl)-propyl methacrylate): In a 500 mL Erlenmeyer flask, a monomer premix was prepared by combining n-butyl acrylate (nBA, 87.5 g), ethyl acrylate (EA, 50.1 g), glycidyl methacrylate (GMA, 25.0 g), acrylonitrile (AN, 50.0 g), 3-(tris(trimethylsilyoxy)silyl)propyl methacrylate (TMPS, 37.7 g), and acetone (200.0 g) followed by transferring to a 600 mL addition tube and purging with nitrogen for 40 minutes. In a 100 mL addition tube, an initiator solution was prepared by combining 1.2662 g of 2,2'-azobisisobutyronitrile (AIBN) and 28.9730 g of acetone. The two addition tubes were mounted on a Claisen adaptor which was connected to a 4-neck, 2 L round bottom flask heated to 60ºC via an oil bath and equipped with an overhead stirrer, water-jacketed condenser, and thermocouple. To the flask was added 53 mL of the monomer premix, which was stirred at 150 rpm for five minutes. This was followed by addition of 2.5 mL of the initiator solution and heating for 15 minutes. The mixing speed was increased to 300 rpm and the remaining monomer premix and initiator solutions were co-slow added to the 2 L flask over the course of two hours 15 minutes and four hours 15 minutes, respectively. The contents were stirred for an additional three hours followed by cooling overnight. A scavenger solution was then prepared from 1.1011 g of 75% *t*-amyl peroxypivalate in mineral spirits dissolved in 19.9440 g of acetone. The scavenging solution was slow added to the flask at 60ºC over two hours followed by heating for an additional two hours. At the end of the hold, a modified Dean-Stark trap was attached to the flask and acetone was removed while slowly adding carbitol acetate to maintain manageable viscosity.

The title polymer was obtained as a clear, slightly yellow polymer solution (384.7 g) at 50.2% solids. Molecular weight was determined via GPC using THF as the mobile phase and polystyrene standards to give $M_n$= 25,704 g/mol, $M_w$=67,920 g/mol, and PDI=2.64. Glass transition temperature was determined as -23.7ºC on second heat via a TA Instruments Q100 modulated DSC heating from room temperature to 110ºC at 10ºC/minute, followed by a rapid cool to -90ºC, then a second heat from -90ºC to 110ºC at 10ºC/minute. Viscosity was determined as 5243 cP on a Brookfield cone and plate viscometer using Spindle 51 at 50ºC and 5.0 rpm at 45% solids. Comonomer incorporation was determined via C-13 NMR in deuterated chloroform to give (by weight) 36% nBA, 19% EA, 8% GMA, 18% AN, and 19% TMPS. Residual monomer and solvent was determined as 1.7% nBA, 0.65% EA, 0.01% GMA, 0.31% AN, 0.01% TMPS, and 4.8% acetone (by weight) via GC and external standards.

EXAMPLE 4: PREPARATION AND CHARACTERIZATION OF POLY(N-BA-*co*-EA-*co*-GMA-*co*-AN-*co*-TMPS): A monomer premix was prepared by combining nBA (100 g), EA (50 g), GMA (25 g), AN (25 g), and TMPS (50 g). An initial charge of monomer premix (37.5 g), acetone (25 g) and AIBN (0.19 g) were added to a 2 L, 4-neck, round bottom flask equipped with a stainless steel stirrer, thermometer, addition funnel, and condenser. The initial charge was heated to reflux while stirring and held at that temperature for 15 minutes. To the remaining monomer premix was added acetone (15g). An initiator solution was prepared by combining AIBN (2.4 g) and acetone (185 g). The monomer premix and initiator solutions were slow added over two hours and three hours, respectively, while maintaining reflux. At the end of the addition, the flask contents were stirred for three hours while maintaining reflux, then cooled overnight. To the flask at reflux, a scavenger solution (2.5 g *t*-amyl peroxypivalate and 25 g acetone) was added over two hours and held at reflux for one hour while stirring. At the end of the hold, a modified Dean-Stark trap was attached to the flask and acetone was removed while slowly adding carbitol acetate to maintain manageable viscosity. Distillation was continued until no further distillate was removed at 110°C after 30 minutes.

The title polymer was obtained as a clear, colorless solution at 50.6% solids. Molecular weight was determined via GPC using THF as the mobile phase and polystyrene standards to give $M_n$=38,342 g/mol, $M_w$=109,342 g/mol, and PDI=2.87. Glass transition temperature was determined as -6.9ºC on second heat via a TA Instruments Q100 modulated DSC heating from room temperature to 110ºC at 10ºC/minute, followed by a rapid cool to -90ºC, then a second heat from -90ºC to 110ºC at 10ºC/minute. Viscosity was determined as 1,228 cP on a Brookfield cone and plate viscometer using Spindle 51 at 50ºC and 5.0 rpm at 45% solids. Comonomer incorporation was determined via C-13 NMR in deuterated chloroform to give (by weight) 42% nBA, 17% EA, 8% GMA, 10% AN, and 23% TMPS.

EXAMPLE 5: PREPARATION AND CHARACTERIZATION OF POLY(N-BA-*co*-EA-*co*-GMA-*co*-AN-*co*-TMPS): In a 500 mL Erlenmeyer flask, a monomer premix was prepared by combining nBA (35.1 g), EA (20.1 g), GMA (10.1 g), AN (20.1 g), TMPS (15.3 g), and ethyl acetate (90.5 g) followed by purging with nitrogen for 40 minutes. An initiator stock solution was prepared by combining 1.001 g of AIBN and 20.23850 g of ethyl acetate. The monomer premix and initiator stock solutions were dispensed via separate pumps through septa in a Claisen adaptor, which was connected to a 4-neck, 500 mL, round bottom flask heated to 80ºC via an oil bath and equipped with an overhead stirrer, water-jacketed condenser, and thermocouple. To the 500 mL round bottom flask was added 20 mL of the monomer premix, which was stirred at 300 rpm for five minutes. This was followed by addition of 1.13 mL of the initiator stock solution and heating for 20 minutes. The remaining monomer premix and 10.77 mL initiator stock solution were co-slow added to the 500 mL round bottom flask over the course of three hours 20 minutes and four hours 25 minutes, respectively. The contents were stirred for an additional four hours 25 minutes followed by cooling overnight. A scavenger solution was then prepared from 0.8261 g of 75% *t*-amyl peroxypivalate In mineral spirits dissolved in 17.1295 g of ethyl acetate. The scavenging solution was slow added to the flask at 80ºC over one hour followed by heating for an additional one hour. At the end of the hold, a modified Dean-Stark trap was attached to the flask and ethyl acetate was removed while slowly adding carbitol acetate to maintain manageable viscosity.

The title polymer was obtained as a clear, slightly yellow polymer solution (151.4g) at 52.8 % solids. Molecular weight was determined via GPC using THF as the mobile phase and polystyrene standards to give $M_n$= 32,106 g/mol, $M_w$=71,754 g/mol, and PDI=2.23. Glass transition temperature was determined as -17.3ºC on second heat via a TA Instruments Q100 modulated DSC heating from room temperature to 110ºC at 10ºC/minute, followed by a rapid cool to -90ºC, then a second heat from -90ºC to 110ºC at 10ºC/minute. Viscosity was determined as 5161 cP on a Brookfield cone and plate viscometer using Spindle 51 at 50ºC and 5.0 rpm at 45% solids. Comonomer incorporation was determined via C-13 NMR in deuterated chloroform to give (by weight) 36% nBA, 18% EA, 9% GMA, 18% AN, and 19% TMPS. Residual monomer and solvent was determined as 0.06% nBA, <0.01% EA, <0.01 % GMA, 0.01% AN, 0.01% TMPS, and 0.03% ethyl acetate (by weight) via GC and external standards.

EXAMPLE 6: PREPARATION AND CHARACTERIZATION OF POLY(N-BA-*co*-EA-*co*-GMA-*co*-AN-*co*-TMPS): A monomer premix was prepared by combining nBA (100 g), EA (50 g), GMA (25 g), AN (25 g), TMPS (50 g). An initial charge of monomer premix (37.5 g), carbitol acetate (25 g) and AIBN (0.19 g) were added to a 2 L, 4-neck, round bottom flask equipped with a stainless steel stirrer, thermometer, addition funnel, and condenser. The initial charge was heated to 75ºC while stirring and held at that temperature for 15 minutes. To the remaining monomer premix was added carbitol acetate (15 g). An initiator solution was prepared by combining AIBN (2.4 g) and carbitol acetate (185 g). The monomer premix and initiator solutions were slow added over two hours and three hours, respectively, while maintaining 75ºC. At the end of the addition, the flask contents were stirred for three hours while maintaining 75ºC, then cooled overnight. To the flask at 75ºC, a scavenger solution (2.5 g *t*-amyl peroxypivalate and 25 g carbitol acetate) was added over two hours and held at 75ºC for one hour while stirring.

The title polymer was obtained as a clear, light yellow solution at 49.5% solids. Molecular weight was determined via GPC using THF as the mobile phase and polystyrene standards to give $M_n$=13,868 g/mol, $M_w$=58,510 g/mol, and PDI=4.22. Glass transition temperature was determined as -11.5ºC on second heat via a TA Instruments Q100 modulated DSC heating from room temperature to 110ºC at 10ºC/minute, followed by a rapid cool to -90ºC, then a second heat from -90ºC to 110ºC at 10ºC/minute. Viscosity was determined as 245.8 cP on a Brookfield cone and plate viscometer using Spindle 51 at 50ºC and 5.0 rpm at 45% solids. Comonomer incorporation was determined via C-13 NMR in deuterated chloroform to give (by weight) 41% nBA, 19% EA, 8% GMA, 9% AN, and 23% TMPS.

EXAMPLE 7: PREPARATION AND CHARACTERIZATION OF POLY(N-BA-*co*-EA-*co*-GMA-*co*-AN-*co*-TMPS)]: In a one L Erlenmeyer flask, a monomer premix was prepared by combining nBA (122.5 g), EA (70.5 g), GMA (35.3 g), AN (70.2 g), TMPS (52.5 g), and ethyl acetate (316.0 g) followed by purging with nitrogen for 35 minutes. An initiator stock solution was prepared by combining 2.0162 g of AIBN and 40.6161 g of ethyl acetate. The monomer premix and initiator solutions were dispensed via separate pumps through septa in a Claisen adaptor which was connected to a 4-neck, one L, round bottom flask heated to 80ºC via an oil bath and equipped with an overhead stirrer, water-jacketed condenser, and thermocouple. To the one L round bottom flask was added 66.5 mL of the monomer premix, which was stirred at 300 rpm for five minutes. This was followed by addition of 4.11 mL of the initiator stock solution and heating for 27 minutes. The remaining monomer premix and 34.96 mL initiator stock solution were co-slow added to the one L round bottom flask over the course of three hours 20 minutes and five hours 13 minutes, respectively. The contents were stirred for an additional four hours followed by cooling overnight. A scavenger solution was then prepared from 2.3620 g of 75% *t*-amyl peroxypivalate in mineral spirits dissolved in 6.0589 g of ethyl acetate. The scavenging solution was slow added to the flask at 80ºC over one hour followed by heating for an additional one hour. At the end of the hold, a modified Dean-Stark trap was attached to the flask and ethyl acetate was removed while slowly adding carbitol acetate to maintain manageable viscosity.

The polymer solution was then divided into two parts. A large portion (236.8 g) of the resulting clear, slightly yellow polymer solution was separated to give the title polymer at 50.3% solids. Molecular weight was determined via GPC using THF as the mobile phase and polystyrene standards to give $M_n$= 32,175 g/mol, $M_w$=78,729 g/mol, and PDI=2.45. Glass transition temperature was determined as -15.6ºC on second heat via a TA Instruments Q100 modulated DSC heating from room temperature to 110ºC at 10ºC/minute, followed by a rapid cool to -90ºC, then a second heat from -90ºC to 110ºC at 10ºC/minute. Viscosity was determined as 4505 cP on a Brookfield cone and plate viscometer using Spindle 51 at 50ºC and 5.0 rpm at 45% solids. Comonomer incorporation was determined via C-13 NMR in deuterated chloroform to give (by weight) 36.3% nBA, 18.3% EA, 7.8% GMA, 18.4% AN, and 19.3% TMPS. Residual monomer was determined as 0.31% nBA, 0.01% EA, 0.01% GMA, <50 ppm AN, and 0.01% TMPS (by weight) via GC and external standards.

EXAMPLE 8: PREPARATION AND CHARACTERIZATION OF POLY(N-BA-*co*-EA-*co*-GMA-*co*-AN-*co*-TMPS)]: The remaining polymer solution from Example 7 was diluted with 200 mL of ethyl acetate and precipitated into 2.5 L of rapidly agitated methanol. The supernatant was removed and the precipitated polymer washed with 3 x 1.5 L portions of methanol followed by drying under vacuum at 55ºC to give 170.6 g of polymer. To 164.5 g of this polymer was added 164.7 g of carbitol acetate to give a 49.9% solids solution of the title polymer. Molecular weight was determined via GPC using THF as the mobile phase and polystyrene standards to give $M_n$= 49,954 g/mol, $M_w$=90,030 g/mol, and PDI=1.80. Glass transition temperature was determined as -6.4ºC on second heat via a TA Instruments Q100 modulated

DSC heating from room temperature to 110ºC at 10ºC/minute, followed by a rapid cool to -90ºC, then a second heat from -90ºC to 110ºC at 10ºC/minute. Viscosity was determined as 6307 cP on a Brookfield cone and plate viscometer using Spindle 51 at 50ºC and 5.0 rpm at 45% solids. Comonomer incorporation was determined via C-13 NMR in deuterated chloroform to give (by weight) 35.0% nBA, 18.2% EA, 9.1% GMA, 18.4% AN, and 19.3% TMPS. Residual monomer was determined as <50 ppm nBA, <25 ppm EA, 50 ppm GMA, <50 ppm AN, and 46 ppm TMPS (by weight) via GC and external standards.

EXAMPLE 9: PREPARATION AND CHARACTERIZATION OF POLY(N-BA-*co*-EA-*co*-GMA-*co*-AN-*co*-TMPS): In a 500 mL Erlenmeyer flask, a monomer premix was prepared by combining nBA (35.6 g), EA (20.3 g), GMA (10.2 g), AN (20.1 g), TMPS (15.1 g), and ethyl acetate (92.2 g) followed by purging with nitrogen for 25 minutes. An initiator stock solution was prepared by combining 0.1920 g of AIBN and 63.9312 g of ethyl acetate. The monomer premix and initiator solutions were dispensed via separate pumps through septa in a Claisen adaptor which was connected to a 4-neck, 500 mL, round bottom flask heated to 80ºC via an oil bath and equipped with an overhead stirrer, water-jacketed condenser, and thermocouple. To the 500 mL round bottom flask was added 22.5 mL of the monomer premix, which was stirred at 300 rpm for five minutes. This was followed by addition of 3.70 mL of the initiator stock solution and heating for 20 minutes. The remaining monomer premix and 33.33 mL initiator stock solution were co-slow added to the 500 mL round bottom flask over the course of two hours 52 minutes and three hours two minutes, respectively. The contents were stirred for an additional three hours eight minutes followed by cooling overnight. A scavenger solution was then prepared from 0.1919 g of 75% *t*-amyl peroxypivalate in mineral spirits dissolved in 19.0578 g of ethyl acetate. The scavenging solution was slow added to the flask at 80ºC over one hour followed by heating for an additional one hour. The clear, colorless polymer solution was then precipitated into 1.5 L of rapidly agitated methanol.

The supernatant was removed and the precipitated polymer washed with 2x1.0 L portions of methanol followed by drying under vacuum at 55ºC to give 28.4g of polymer. To 26.26 g of this polymer was added 26.32 g of carbitol acetate to give a 50.0% solids solution of the title polymer. Molecular weight was determined via GPC using THF as the mobile phase and polystyrene standards to give $M_n$= 68,816 g/mol, $M_w$=110,880 g/mol, and PDI=1.61. Glass transition temperature was determined as 13.1ºC on second heat via a TA Instruments Q100 modulated DSC heating from room temperature to 110ºC at 10ºC/minute, followed by a rapid cool to -90 ºC, then a second heat from -90ºC to 110ºC at 10ºC/minute. Viscosity was determined as 10,070 cP on a Brookfield cone and plate viscometer using Spindle 51 at 50ºC and 5.0 rpm at 45% solids. Residual monomer was determined as 0.02% nBA, <25 ppm EA, 0.01% GMA, <50 ppm AN, and 0.03% TMPS (by weight) via GC and external standards.

EXAMPLE 10: POLY(N-BA-*co*-EA-*co*-GMA-*co*-AN-*co*-TMPS) PREPARED BY BLENDING EXAMPLES 8 AND 9: A polymer blend was prepared by mixing 102.4 g of the polymer from Example 8 and 40.9 g of the polymer from Example 9 to give 143.3 g of 49.3% solids solution of the title polymer. Molecular weight was determined via GPC using THF as the mobile phase and polystyrene standards to give $M_n$= 50,497 g/mol, $M_w$=88,221 g/mol, and PDI=1.75. Glass transition temperature was determined as 11.0ºC on second heat via a TA Instruments Q100 modulated DSC heating from room temperature to 110ºC at 10ºC/minute, followed by a rapid cool to -90ºC, then a second heat from -90ºC to 110ºC at 10ºC/minute. Viscosity was determined as 6062 cP on a Brookfield cone and plate viscometer using Spindle 51 at 50 ºC and 5.0 rpm at 45% solids. Comonomer incorporation was determined via C-13 NMR in deuterated chloroform to give (by weight) 33% nBA, 18% EA, 10% GMA, 17% AN, and 22% TMPS.

EXAMPLE 11: PREPARATION AND CHARACTERIZATION OF POLY(N-BA-*co*-EA-*co*-GMA-*co*-AN-*co*-TMPS): In a one L Erlenmeyer flask, a monomer premix was prepared by combining nBA (128.9 g), EA (50.6 g), GMA (25.2 g), AN (50.2 g), TMPS (12.8 g), and ethyl acetate (251.2 g). An initiator stock solution was prepared by combining 2.9950 g of AIBN and 23.0 mL of ethyl acetate. The monomer premix was dispensed through a septum connected to a 4-neck, one L round bottom flask heated to 80ºC via an oil bath and equipped with an overhead stirrer, water-jacketed condenser, and thermocouple. To the one L round bottom flask was added 112 mL of the monomer premix stirred at 300 rpm for five minutes. This was followed by addition of 1.9 mL of the initiator stock solution and heating for 20 minutes. To the remaining monomer premix was added 7.7 mL of initiator stock solution. This solution was then slow added to the one L round bottom flask over the course of two hours 42 minutes then heated an additional three hours 8 minutes. A scavenger stock solution was prepared from 3.3567 g of 75% *t*-amyl peroxypivalate in mineral spirits dissolved in 20.0 mL of ethyl acetate. To the flask at 70ºC, 8.0 mL of scavenger stock solution was added over one hour, heated for an additional two hours, and cooled overnight. At the end of the hold, a modified Dean-Stark trap was attached to the flask and ethyl acetate was removed while slowly adding carbitol acetate to maintain manageable viscosity.

The title polymer was obtained as a clear, slightly yellow polymer solution (493.0g) at 47.0% solids. Molecular weight was determined via GPC using THF as the mobile phase and polystyrene standards to give $M_n$= 33,259 g/mol, $M_w$=81, 114 g/mol, and PDI=2.44. Glass transition temperature was determined as -0.9ºC on second heat via a TA Instruments Q100 modulated DSC heating from room temperature to 110ºC at 10ºC/minute, followed by a rapid cool to -90ºC, then a second heat from -90ºC to 110ºC at 10ºC/minute. Viscosity was determined as 6226 cPs on a Brookfield cone and plate viscometer using Spindle 51 at 50ºC and 5.0 rpm at 45% solids. Comonomer incorporation was determined

via C-13 NMR in deuterated chloroform to give (by weight) 52% nBA, 19% EA, 8% GMA, 17% AN, and 4% TMPS. Residual monomer was determined as 1.6% nBA, 0.22% EA, <0.01% GMA, 0.02% AN, and <0.01% TMPS (by weight) via GC and external standards.

EXAMPLE 12: PREPARATION AND CHARACTERIZATION OF POLY(N-BA-*co*-EA-*co*-GMA-*co*-AN-*co*-TMPS): In a one L Erlenmeyer flask, a monomer premix was prepared by combining nBA (118.8 g), EA (49.8 g), GMA (25.6 g), AN (49.1 g), TMPS (6.3 g), and ethyl acetate (258.4 g). An initiator stock solution was prepared by combining 2.9950 g of AIBN and 23.0 mL of ethyl acetate. The monomer premix was dispensed through a septum connected to a 4-neck, one L, round bottom flask heated to 80ºC via an oil bath and equipped with an overhead stirrer, water-jacketed condenser, and thermocouple. To the one L round bottom flask was added 116 mL of the monomer premix, which was stirred at 300 rpm for five minutes. This was followed by addition of 1.9 mL of the initiator stock solution and heating for 20 minutes. To the remaining monomer premix was added 7.7 mL of initiator stock solution. This solution was then slow added to the one L round bottom flask over the course of two hours 34 minutes then heated an additional three hours 8 minutes. A scavenger stock solution was prepared from 3.3567 g of 75% *t*-amyl peroxypivalate in mineral spirits dissolved in 20.0 mL of ethyl acetate. To the flask at 70ºC, 8.0 mL of scavenger stock solution was added over one hour, heated an additional two hours, and cooled overnight. At the end of the hold, a modified Dean-Stark trap was attached to the flask and ethyl acetate was removed while slowly adding carbitol acetate to maintain manageable viscosity.

The title polymer was obtained as a clear, slightly yellow polymer solution (462.6 g) at 47.2% solids. Molecular weight was determined via GPC using THF as the mobile phase and polystyrene standards to give $M_n$= 35,237 g/mol, $M_w$=77,662 g/mol, and PDI=2.20. Glass transition temperature was determined as 2.6ºC on second heat via a TA Instruments Q100 modulated DSC heating from room temperature to 110ºC at 10ºC/minute, followed by a rapid cool to -90ºC, then a second heat from -90ºC to 110ºC at 10ºC/minute. Viscosity was determined as 6307 cP on a Brookfield cone and plate viscometer using Spindle 51 at 50ºC and 5.0 rpm at 45% solids. Comonomer incorporation was determined via C-13 NMR in deuterated chloroform to give (by weight) 51% nBA, 19% EA, 8% GMA, 18% AN, and 4% TMPS. Residual monomer was determined as 1.2% nBA, 0.08% EA, <0.01 % GMA, <0.01 % AN, and <0.01 % TMPS (by weight) via GC and external standards.

EXAMPLE 13: PREPARATION AND CHARACTERIZATION OF POLY(N-BA-*co*-GMA-*co*-AN-*co*-TMPS): In a one L Erlenmeyer flask, a monomer premix was prepared by combining nBA (147.5 g), GMA (25.1 g), AN (65.3 g), TMPS (12.5 g), and ethyl acetate (250.0 g). An initiator stock solution was prepared by combining 3.0062 g of AIBN and 50.0 mL of ethyl acetate. The monomer premix was dispensed through a septum connected to a 4-neck, one L, round bottom flask heated to 80ºC via an oil bath and equipped with an overhead stirrer, water-jacketed condenser, and thermocouple. To the one L round bottom flask was added 100.7 g of the monomer premix, which was stirred at 200 rpm for five minutes. This was followed by addition of 4.2 mL of the initiator stock solution and heating for 20 minutes. To the remaining monomer premix was added 12.5 mL of initiator stock solution. This solution was then slow added to the one L round bottom flask over the course of three hours 8 minutes, followed by the slow addition of 4.1 mL of additional initiator stock solution over the course of one hour 18 minutes, and then heated for a final three hours two minutes. A scavenger stock solution was prepared from 4.1933 g of 75% *t*-amyl peroxypivalate in mineral spirits dissolved in 22.0 mL of ethyl acetate. To the flask at 80ºC, 8.74 mL of scavenger stock solution was added over one hour, heated an additional one hour 30 minutes, and cooled overnight. At the end of the hold, a modified Dean-Stark trap was attached to the flask and ethyl acetate was removed while slowly adding carbitol acetate to maintain manageable viscosity.

The title polymer was obtained as a clear, slightly yellow polymer solution (484.5 g) at 45.9% solids. Molecular weight was determined via GPC using THF as the mobile phase and polystyrene standards to give $M_n$= 22,514 g/mol, $M_w$=71,137 g/mol, and PDI=3.16. Glass transition temperature was determined as 12.0ºC on second heat via a TA Instruments Q100 modulated DSC heating from room temperature to 110ºC at 10ºC/minute, followed by a rapid cool to -90ºC, then a second heat from -90ºC to 110ºC at 10ºC/minute. Viscosity was determined as 8110 cP on a Brookfield cone and plate viscometer using Spindle 51 at 50ºC and 5.0 rpm at 45% solids. Comonomer incorporation was determined via C-13 NMR in deuterated chloroform to give (by weight) 64.1% nBA, 7.2% GMA, 24.4% AN, and 4.3% TMPS. Residual monomer and solvent was determined as 0.74% nBA, <0.01% GMA, 0.02% AN, <0.01% TMPS, and 3.6% ethyl acetate (by weight) via GC and external standards.

EXAMPLE 14: PREPARATION AND CHARACTERIZATION OF POLY(N-BA-*co*-GMA-*co*-AN-*co*-TMPS): In a one L Erlenmeyer flask, a monomer premix was prepared by combining nBA (153.8 g), GMA (25.2 g), AN (65.1 g), TMPS (6.2 g), and ethyl acetate (251.0 g). An initiator stock solution was prepared by combining 3.0062 g of AIBN and 50.0 mL of ethyl acetate. The monomer premix was dispensed through a septum connected to a 4-neck, one L, round bottom flask heated to 80ºC via an oil bath and equipped with an overhead stirrer, water-jacketed condenser, and thermocouple. To the one L round bottom flask was added 100.2 g of the monomer premix, which was stirred at 200 rpm for five minutes. This was followed by addition of 4.2 mL of the initiator stock solution and heating for 20 minutes. To the remaining monomer premix was added 12.5 mL of initiator stock solution. This solution was then slow added to the one L round bottom flask over the course of three hours 8 minutes, followed by the slow addition of 4.1 mL of additional

initiator stock solution over the course of one hour 18 minutes, and then heated for a final three hours two minutes. A scavenger stock solution was prepared from 4.1933 g of 75% *t*-amyl peroxypivalate in mineral spirits dissolved in 22.0 mL of ethyl acetate. To the flask at 80ºC, 8.74 mL of scavenger stock solution was added over one hour, heated an additional one hour 30 minutes, and cooled overnight. At the end of the hold, a modified Dean-Stark trap was attached to the flask and ethyl acetate was removed while slowly adding carbitol acetate to maintain manageable viscosity.

The title polymer was obtained as a clear, slightly yellow polymer solution (502.3 g) at 44.9% solids. Molecular weight was determined via GPC using THF as the mobile phase and polystyrene standards to give $M_n$= 22,293 g/mol, $M_w$=73,416 g/mol, and PDI=3.29. Glass transition temperature was determined as 10.9ºC on second heat via a TA Instruments Q100 modulated DSC heating from room temperature to 110ºC at 10ºC/minute, followed by a rapid cool to -90ºC, then a second heat from -90ºC to 110ºC at 10ºC/minute. Viscosity was determined as 8437 cP on a Brookfield cone and plate viscometer using Spindle 51 at 50ºC and 5.0 rpm at 45% solids. Comonomer incorporation was determined via C-13 NMR in deuterated chloroform to give (by weight) 65% nBA, 7% GMA, 24% AN, and 4% TMPS. Residual monomer and solvent was determined as 0.66% nBA, 0.01% GMA, 0.02% AN, <0.01% TMPS, and 4.8% ethyl acetate (by weight) via GC and external standards.

EXAMPLE 15: PREPARATION AND CHARACTERIZATION OF POLY(N-BA-*co*-GMA-*co*-AN-*co*-TMPS): In a one L Erlenmeyer flask, a monomer premix was prepared by combining nBA (112.6 g), GMA (50.0 g), AN (50.2 g), TMPS (37.5 g), and acetone (200.2 g). An initiator stock solution was prepared by combining 3.1458 g of 2,2'-azobis (2,4-dimethyl-valeronitrile) (Vazo®-52) and 61.8300 g of acetone. The monomer premix and initiator solutions were dispensed via separate pumps through septa in a Claisen adaptor which was connected to a 4-neck, one L, round bottom flask heated to 75ºC via an oil bath and equipped with an overhead stirrer, water-jacketed condenser, and thermocouple. To the one L round bottom flask was added 45.10 g of the monomer premix, which was stirred at 200 rpm for five minutes. This was followed by addition of 2.5833 g of the initiator stock solution and heating for 30 minutes at reflux. The remaining monomer premix and 29.37 mL initiator stock solution were co-slow added to the one L round bottom flask (reflux, 300 rpm) over the course of one hour 50 minutes and three hours, respectively. The contents were stirred for an additional three hours 30 minutes at reflux. A scavenger solution prepared from 2.5040 g of 75% *t*-amyl peroxypivalate in mineral spirits dissolved in 25.1760 g of acetone was slow added to the flask at reflux over one hour followed by heating an additional one hour and cooling overnight. A modified Dean-Stark trap was attached to the one L round bottom flask and the heat increased to distill off acetone with portions of carbitol acetate added to maintain manageable viscosity.

The title polymer was obtained as a clear, slightly yellow polymer solution (462.9 g) at 49.8% solids. Molecular weight was determined via GPC using THF as the mobile phase and polystyrene standards to give $M_n$=27,899 g/mol, $M_w$=67,123 g/mol, and PDI=2.42. Glass transition temperature was determined as 15.0ºC on second heat via a TA Instruments Q100 modulated DSC heating from room temperature to 110ºC at 10ºC/minute, followed by a rapid cool to -90ºC, then a second heat from -90ºC to 110ºC at 10ºC/minute. Viscosity was determined as 6226 cP on a Brookfield cone and plate viscometer using Spindle 51 at 50ºC and 5.0 rpm at 45% solids. Comonomer incorporation was determined via C-13 NMR in deuterated chloroform to give (by weight) 47% nBA, 17% GMA, 18% AN, and 18% TMPS.

EXAMPLE 16: PREPARATION AND CHARACTERIZATION OF POLY(N-BA-*co*-GMA-*co*-AN-*co*-TMPS): In a one L Erlenmeyer flask, a monomer premix was prepared by combining nBA (125.0 g), GMA (37.5 g), AN (50.0 g), TMPS (37.6 g), and acetone (200.6 g). An initiator stock solution was prepared by combining 3.1458 g of Vazo®-52 and 61.8300 g of acetone. The monomer premix and initiator solutions were dispensed via separate pumps through septa in a Claisen adaptor which was connected to a 4-neck, one L round bottom flask heated to 75ºC via an oil bath and equipped with an overhead stirrer, water-jacketed condenser, and thermocouple. To the one L round bottom flask was added 45.45 g of the monomer premix, which was stirred at 200 rpm for five minutes. This was followed by addition of 2.5871 g of the initiator stock solution and heating for 28 minutes at reflux. The remaining monomer premix and 29.37 mL initiator stock solution were co-slow added to the one L round bottom flask (reflux, 300 rpm) over the course of one hour 54 minutes and three hours, respectively. The contents were stirred for an additional three hours 36 minutes at reflux. A scavenger solution prepared from 2.5635 g of 75% *t*-amyl peroxypivalate in mineral spirits dissolved in 31.7040 g of acetone was slow added to the flask at reflux over one hour followed by heating an additional one hour and cooling overnight. A modified Dean-Stark trap was attached to the one L round bottom flask and the heat increased to distill off acetone with portions of carbitol acetate added to maintain manageable viscosity.

The title polymer was obtained as a clear, slightly yellow polymer solution (497.6 g) at 46.3% solids. Molecular weight was determined via GPC using THF as the mobile phase and polystyrene standards to give $M_n$=28,483 g/mol, $M_w$=99,696 g/mol, and PDI=2.30. Glass transition temperature was determined as 10.0ºC on second heat via a TA Instruments Q100 modulated DSC heating from room temperature to 110ºC at 10ºC/minute, followed by a rapid cool to -90ºC, then a second heat from -90ºC to 110ºC at 10ºC/minute. Viscosity was determined as 4587 cP on a Brookfield cone and plate viscometer using Spindle 51 at 50ºC and 5.0 rpm at 45% solids. Comonomer incorporation was determined via C-13 NMR in deuterated chloroform to give (by weight) 51% nBA, 12% GMA, 18% AN, and 18%TMPS.

EXAMPLE 17: PREPARATION AND CHARACTERIZATION OF POLY(N-BA-*co*-GMA-*co*-AN-*co*-TMPS): In a one L Erlenmeyer flask, a monomer premix was prepared by combining nBA (150.1 g), GMA (12.6 g), AN (50.0 g),

TMPS (37.6 g), and acetone (200.9 g). An initiator solution was prepared by combining 1.2582 g of Vazo®-52 and 26.2500 g of acetone. The monomer premix and initiator solution were dispensed via a pump through a septum and an addition tube, respectively, connected to a Claisen adaptor which was attached to a 4-neck, one L round bottom flask heated to 75ºC via an oil bath and equipped with an overhead stirrer, water-jacketed condenser, and thermocouple. To the one L round bottom flask was added 48.71 g of the monomer premix, which was stirred at 200 rpm for five minutes. This was followed by addition of ~3 mL of the initiator stock solution and heating for 20 minutes at reflux. The remaining monomer premix and initiator solution were co-slow added to the one L round bottom flask (reflux, 200 rpm) over the course of two hours and three hours, respectively. The contents were stirred for an additional four hours at reflux then cooled overnight. A scavenger solution prepared from 2.6148 g of 75% *t*-amyl peroxypivalate in mineral spirits dissolved in 25.5160 g of acetone was slow added to the flask at reflux over one hour followed by heating an additional one hour. A modified Dean-Stark trap was attached to the one L round bottom flask and the heat increased to distill off acetone with portions of carbitol acetate added to maintain manageable viscosity.

The title polymer was obtained as a clear, slightly yellow polymer solution (484.2 g) at 47.5% solids. Molecular weight was determined via GPC using THF as the mobile phase and polystyrene standards to give $M_n$=34,999 g/mol, $M_w$=81,134 g/mol, and PDI=2.32. Glass transition temperature was determined as 4.6ºC on second heat via a TA Instruments Q100 modulated DSC heating from room temperature to 110ºC at 10ºC/minute, followed by a rapid cool to -90ºC, then a second heat from -90ºC to 110ºC at 10ºC/minute. Viscosity was determined as 5406 cP on a Brookfield cone and plate viscometer using Spindle 51 at 50ºC and 5.0 rpm at 45% solids. Comonomer incorporation was determined via C-13 NMR in deuterated chloroform to give (by weight) 60% nBA, 4% GMA, 18% AN, and 18% TMPS.

EXAMPLE 18: PREPARATION AND CHARACTERIZATION OF POLY(N-BA-*co*-GMA-*co*-AN-*co*-TMPS): In a one L Erlenmeyer flask, a monomer premix was prepared by combining nBA (156.2 g), GMA (6.4 g), AN (50.0 g), TMPS (37.6 g), and acetone (203.6 g). An initiator solution was prepared by combining 1.2531 g of Vazo®-52 and 25.2532 g of acetone. The monomer premix and Initiator solution were dispensed via a pump through a septum and an addition tube, respectively, connected to a Claisen adaptor which was attached to a 4-neck, one L, round bottom flask heated to 75 °C via an oil bath and equipped with an overhead stirrer, water-jacketed condenser, and thermocouple. To the one L round bottom flask was added 48.59 g of the monomer premix, which was stirred at 200 rpm for five minutes. This was followed by addition of -3 mL of the initiator stock solution and heating for 20 minutes at reflux. The remaining monomer premix and initiator solution were co-slow added to the one L round bottom flask (reflux, 200 rpm) over the course of two hours and three hours, respectively. The contents were stirred for an additional four hours at reflux then cooled overnight. A scavenger solution prepared from 2.5828 g of 75% *t*-amyl peroxypivalate in mineral spirits dissolved in 37.2680 g of acetone was slow added to the flask at reflux over one hour followed by heating an additional one hour. At the end of the hold, a modified Dean-Stark trap was attached to the flask and acetone was removed while slowly adding carbitol acetate to maintain manageable viscosity.

The title polymer was obtained as a clear, slightly yellow polymer solution (477.1 g) at 48.6% solids. Molecular weight was determined via GPC using THF as the mobile phase and polystyrene standards to give $M_n$=33,282 g/mol, $M_w$=82,738 g/mol, and PDI=2.49. Glass transition temperature was determined as 4.1ºC on second heat via a TA Instruments Q100 modulated DSC heating from room temperature to 110ºC at 10ºC/minute, followed by a rapid cool to -90ºC, then a second heat from -90ºC to 110ºC at 10ºC/minute. Viscosity was determined as 5324 cP on a Brookfield cone and plate viscometer using Spindle 51 at 50ºC and 5.0 rpm at 45% solids. Comonomer incorporation was determined via C-13 NMR in deuterated chloroform to give (by weight) 63% nBA, 1% GMA, 18% AN, and 18% TMPS.

Examples 19-23 describe the preparation of a polymer with the general structure shown here:

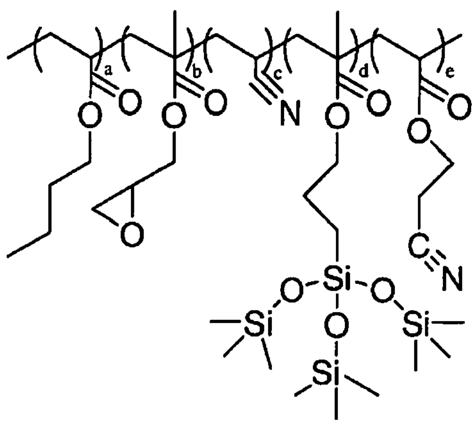

Examples 19-21 describe the preparation of the polymer with varying amounts of the five monomers. Examples

22-23 describe the preparation of the polymer without acrylonitrile (i.e. when c=0%).

EXAMPLE 19: PREPARATION AND CHARACTERIZATION OF POLY(N-BA-*co*-GMA-*co*-AN-*co*-TMPS-*co*-2-CYANOETHYLACRYLATE): In a one L Erlenmeyer flask, a monomer premix was prepared by combining nBA (112.6 g), GMA (25.1 g), AN (50.0 g), TMPS (12.5 g), 2-cyanoethyl acrylate (CEA, 51.8 g) and acetone (200.3 g). An initiator solution was prepared by combining 1.2672 g of Vazo®-52 and 25.0550 g of acetone. The monomer premix and initiator solution were dispensed via a pump through a septum and an addition tube, respectively, connected to a Claisen adaptor which was attached to a 4-neck, one L, round bottom flask heated to 75ºC via an oil bath and equipped with an overhead stirrer, water-jacketed condenser, and thermocouple. To the one L round bottom flask was added 46.12 g of the monomer premix, which was stirred at 200 rpm for five minutes. This was followed by addition of ~3 mL of the initiator stock solution and heating for 22 minutes at reflux. The remaining monomer premix and initiator solution were co-slow added to the one L round bottom flask (reflux, 200 rpm) over the course of one hour 52 minutes and two hours 57 minutes, respectively. The contents were stirred for an additional four hours at reflux then cooled overnight. A scavenger solution prepared from 2.5507 g of 75% *t*-amyl peroxypivalate in mineral spirits dissolved in 28.9540 g of acetone was slow added to the flask at reflux over two hours followed by heating an additional one hour. At the end of the hold, a modified Dean-Stark trap was attached to the flask and acetone was removed while slowly adding carbitol acetate to maintain manageable viscosity.

The title polymer was obtained as a clear, slightly yellow polymer solution (484.5 g) at 48.2% solids. Molecular weight was determined via GPC using THF as the mobile phase and polystyrene standards to give $M_n$=43,526 g/mol, $M_w$=115,920 g/mol, and PDI=2.66. Glass transition temperature was determined as 10.3ºC on second heat via a TA Instruments Q100 modulated DSC heating from room temperature to 110ºC at 10ºC/minute, followed by a rapid cool to -90ºC, then a second heat from -90ºC to 110ºC at 10ºC/minute. Viscosity was determined as 12,610 cP on a Brookfield cone and plate viscometer using Spindle 51 at 50ºC and 5.0 rpm at 45% solids. Comonomer incorporation was determined via C-13 NMR in deuterated chloroform to give (by weight) 52% nBA, 8% GMA, 18% AN, 8% TMPS, and 14% CEA.

EXAMPLE 20: PREPARATION AND CHARACTERIZATION OF POLY(N-BA-*co*-GMA-*co*-AN-*co*-TMPS-*co*-CEA): In a one L Erlenmeyer flask, a monomer premix was prepared by combining nBA (137.5 g), GMA (25.2 g), AN (50.1 g), TMPS (12.6 g), CEA (25.2 g) and acetone (200.5 g). An initiator solution was prepared by combining 1.2771 g of Vazo®-52 and 26.1687 g of acetone. The monomer premix and initiator solution were dispensed via a pump through a septum and an addition tube, respectively, connected to a Claisen adaptor which was attached to a 4-neck, one L, round bottom flask heated to 75ºC via an oil bath and equipped with an overhead stirrer, water-jacketed condenser, and thermocouple. To the one L round bottom flask was added 46.45 g of the monomer premix, which was stirred at 200 rpm for five minutes. This was followed by addition of -3 mL of the initiator stock solution and heating for 20 minutes at reflux. The remaining monomer premix and initiator solution were co-slow added to the one L round bottom flask (reflux, 200 rpm) over the course of one hour 47 minutes and three hours, respectively. The contents were stirred for an additional four hours at reflux then cooled overnight. A scavenger solution prepared from 2.5331 g of 75% *t*-amyl peroxypivalate in mineral spirits dissolved in 25.6418 g of acetone was slow added to the flask at reflux over one hour 30 minutes followed by heating an additional one hour 30 minutes. At the end of the hold, a modified Dean-Stark trap was attached to the flask and acetone was removed while slowly adding carbitol acetate to maintain manageable viscosity.

The title polymer was obtained as a clear, slightly yellow polymer solution (469.7 g) at 47.6% solids. Molecular weight was determined via GPC using THF as the mobile phase and polystyrene standards to give $M_n$=43,337 g/mol, $M_w$=96,250 g/mol, and PDI=2.22. Glass transition temperature was determined as five.4ºC on second heat via a TA Instruments Q100 modulated DSC heating from room temperature to 110ºC at 10ºC/minute, followed by a rapid cool to -90ºC, then a second heat from -90ºC to 110ºC at 10ºC/minute. Viscosity was determined as 7618 cP on a Brookfield cone and plate viscometer using Spindle 51 at 50ºC and 5.0 rpm at 45% solids. Comonomer incorporation was determined via C-13 NMR In deuterated chloroform to give (by weight) 58% nBA, 8% GMA, 18% AN, 8% TMPS, and 8% CEA.

EXAMPLE 21: PREPARATION AND CHARACTERIZATION OF POLY(N-BA-*co*-GMA-*co*-AN-*co*-TMPS-*co*-CEA): In a one L Erienmeyer flask, a monomer premix was prepared by combining nBA (62.87 g), GMA (25.6 g), AN (50.5 g), TMPS (12.6 g), CEA (100.6 g) and acetone (206.0 g). An initiator solution was prepared by combining 1.2598 g of Vazo®-52 and 24.0258 g of acetone. The monomer premix and initiator solution were dispensed via a pump through a septum and an addition tube, respectively, connected to a Claisen adaptor which was attached to a 4-neck, one L round bottom flask heated to 75ºC via an oil bath and equipped with an overhead stirrer, water-jacketed condenser, and thermocouple. To the one L round bottom flask was added 47.99 g of the monomer premix, which was stirred at 200 rpm for five minutes. This was followed by addition of ~3 mL of the initiator stock solution and heating for 20 minutes at reflux. The remaining monomer premix and initiator solution were co-slow added to the one L round bottom flask (reflux, 200 rpm) over the course of one hour 52 minutes and two hours 40 minutes, respectively. The contents were stirred for an additional four hours at reflux then cooled overnight. A scavenger solution prepared from 2.6660 g of 75% *t*-amyl peroxypivalate in mineral spirits dissolved in 25.8925 g of acetone was slow added to the flask at reflux over two hours 9 minutes followed by heating an additional one hour. At the end of the hold, a modified Dean-Stark trap was

attached to the flask and acetone was removed while slowly adding carbitol acetate to maintain manageable viscosity.

The title polymer was obtained as a clear, slightly yellow polymer solution (476.9 g) at 53.7% solids. Molecular weight was determined via GPC using THF as the mobile phase and polystyrene standards to give $M_n$=41,607g/mol, $M_w$=285,182 g/mol, and PDI=6.88. Glass transition temperature was determined as 14.2ºC on second heat via a TA Instruments Q100 modulated DSC heating from room temperature to 110ºC at 10ºC/minute, followed by a rapid cool to -90ºC, then a second heat from -90ºC to 110ºC at 10ºC/minute. Viscosity was determined as 17,610 cP on a Brookfield cone and plate viscometer using Spindle 51 at 50 °C and 5.0 rpm at 45% solids.

EXAMPLE 22: PREPARATION AND CHARACTERIZATION OF POLY(N-BA-*co*-GMA-*co*-TMPS-*co*-CEA): In a one L Erlenmeyer flask, a monomer premix was prepared by combining nBA (112.8 g), GMA (25.0 g), TMPS (12.5 g), CEA (100.1 g), 2-mercaptoethanol (1.38 g), and acetone (200.3 g). An initiator solution was prepared by combining 1.2503 g of Vazo®-52 and 23.9340 g of acetone. The monomer premix and initiator solution were dispensed via a pump through a septum and an addition tube, respectively, connected to a Claisen adaptor which was attached to a 4-neck, one L, round bottom flask heated to 75ºC via an oil bath and equipped with an overhead stirrer, water-jacketed condenser, and thermocouple. To the one L round bottom flask was added 47.07 g of the monomer premix, which was stirred at 200 rpm for five minutes. This was followed by addition of ~3 mL of the initiator stock solution and heating for 20 minutes at reflux. The remaining monomer premix and initiator solution were co-slow added to the one L round bottom flask (reflux, 200 rpm) over the course of one hour 54 minutes and two hours 57 minutes, respectively. The contents were stirred for an additional four hours at reflux then cooled overnight. A scavenger solution prepared from 2.6871 g of 75% *t*-amyl peroxypivalate in mineral spirits dissolved in 26.1319 g of acetone was slow added to the flask at reflux over two hours five minutes followed by heating an additional one hour. At the end of the hold, a modified Dean-Stark trap was attached to the flask and acetone was removed while slowly adding carbitol acetate to maintain manageable viscosity.

The title polymer was obtained as a clear, slightly yellow polymer solution (500.3 g) at 49.2% solids. Molecular weight was determined via GPC using THF as the mobile phase and polystyrene standards to give $M_n$=21,196 g/mol, $M_w$=55,385 g/mol, and PDI=2.61. Glass transition temperature was determined as -19.9ºC on second heat via a TA Instruments Q100 modulated DSC heating from room temperature to 110 °C at 10ºC/minute, followed by a rapid cool to -90ºC, then a second heat from -90°C to 110ºC at 10ºC/minute. Viscosity was determined as 4833 cP on a Brookfield cone and plate viscometer using Spindle 51 at 50ºC and 5.0 rpm at 45% solids. Comonomer incorporation was determined via C-13 NMR in deuterated chloroform to give (by weight) 54% nBA, 9% GMA, 6% TMPS, and 31% CEA.

EXAMPLE 23: PREPARATION AND CHARACTERIZATION OF POLY(N-BA-*co*-GMA-*co*-TMPS-*co*-CEA): A monomer premix was prepared by combining nBA (112.5 g), GMA (50 g), TMPS (37.5 g), CEA (50 g), and acetone (200 g). An initiator solution was prepared by combining Vazo-52 (3.15 g) and acetone (61.83 g). An initial charge of monomer premix (45.1 g), and initiator solution (2.58 g) were added to a 2 L, 4-neck, round bottom flask equipped with a stainless steel stirrer, thermometer, addition funnel, and condenser. The initial charge was heated to reflux while stirring and held at that temperature for 15 minutes. The monomer premix and initiator solutions were slow added over two hours and three hours, respectively, while maintaining reflux. At the end of the addition, the flask contents were stirred for three hours while maintaining reflux, then cooled overnight. To the flask at reflux, a scavenger solution (2.5 g *t*-amyl peroxypivalate and 25 g acetone) was added over two hours and held at reflux for one hour while stirring. At the end of the hold, a modified Dean-Stark trap was attached to the flask and acetone was removed while slowly adding carbitol acetate to maintain manageable viscosity. Distillation was continued until no further distillate was removed at 110°C after 30 minutes.

The title polymer was obtained as a clear, colorless solution at 52.3% solids. Molecular weight was determined via GPC using THF as the mobile phase and polystyrene standards to give $M_n$=25,913 g/mol, $M_w$=111, 680 g/mol, and PDI=4.31. Glass transition temperature was determined as -12.0ºC on second heat via a TA Instruments Q100 modulated DSC heating from room temperature to 110ºC at 10ºC/minute, followed by a rapid cool to -90ºC, then a second heat from -90ºC to 110ºC at 10ºC/minute. Viscosity was determined as 655.4 cP on a Brookfield cone and plate viscometer using Spindle 51 at 50ºC and 5.0 rpm at 45% solids. Comonomer incorporation was determined via C-13 NMR in butyrated chloroform to give (by weight) nBA 59%, TMPS 7%, GMA 18%, CEA 16%.

Examples 24-27 describe the preparation of the polymer containing the general structure shown below with and without acrylonitrile (i.e. when c>0% and c=0%) at various levels of the different monomers:

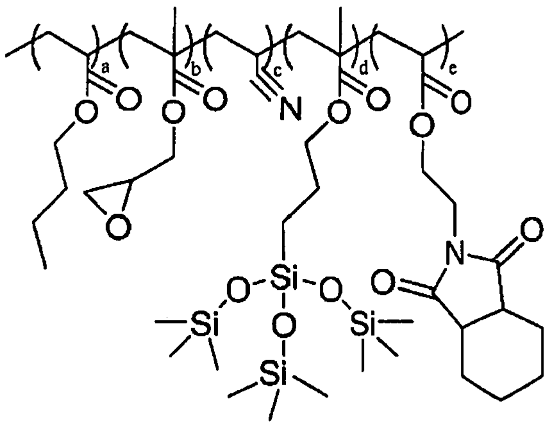

EXAMPLE 24: PREPARATION AND CHARACTERIZATION OF POLY(N-BA-*co*-GMA-*co*-TMPS-*co*-2-(1,2-CYCLOHEXANEDICARBOXYIMIDE)ETHYL ACRYLATE): In a one L Erlenmeyer flask, a monomer premix was prepared by combining nBA (173.4 g), GMA (26.5 g), TMPS (13.4 g), 2-(1,2-cyclohexanedicarboxyimide)ethyl acrylate (Aronix M-140, 53.1 g), and acetone (212.2 g). An initiator solution was prepared by combining 1.3285 g of Vazo®-52 and 26.4652 g of acetone. The monomer premix and initiator solution were dispensed via a pump through a septum and an addition tube, respectively, connected to a Claisen adaptor which was attached to a 4-neck, one L, round bottom flask heated to 75ºC via an oil bath and equipped with an overhead stirrer, water-jacketed condenser, and thermocouple. To the one L round bottom flask was added 48.00 g of the monomer premix, which was stirred at 200 rpm for five minutes. This was followed by addition of -3 mL of the initiator stock solution and heating for 20 minutes at reflux. The remaining monomer premix and initiator solution were co-slow added to the one L round bottom flask (reflux, 200 rpm) over the course of one hour 52 minutes and two hours 55 minutes, respectively. The contents were stirred for an additional four hours at reflux then cooled overnight. A scavenger solution prepared from 2.6620 g of 75% *t*-amyl peroxypivalate in mineral spirits dissolved in 25.7451 g of acetone was slow added to the flask at reflux over two hours followed by heating an additional one hour. At the end of the hold, a modified Dean-Stark trap was attached to the flask and acetone was removed while slowly adding carbitol acetate to maintain manageable viscosity.

The title polymer was obtained as a clear, slightly yellow polymer solution (501.8 g) at 49.9% solids, Molecular weight was determined via GPC using THF as the mobile phase and polystyrene standards to give $M_n$=58,359 g/mol, $M_w$=284,727 g/mol, and PDI=4.96. Glass transition temperature was determined as -21.6ºC on second heat via a TA Instruments Q100 modulated DSC heating from room temperature to 110ºC at 10°C/minute, followed by a rapid cool to -90ºC, then a second heat from -90ºC to 110ºC at 10ºC/minute. Viscosity was determined as 7946 cP on a Brookfield cone and plate viscometer using Spindle 51 at 50ºC and 5.0 rpm at 45% solids. Comonomer incorporation was determined via C-13 NMR in deuterated chloroform to give (by weight) 71% nBA, 9% GMA, 6% TMPS, and 14% M-140.

EXAMPLE 25: PREPARATION AND CHARACTERIZATION OF POLY(N-BA-*co*-GMA-*co*-AN-*co*-TMPS-*co*-M-140): In a one L Erlenmeyer flask, a monomer premix was prepared by combining nBA (112.6 g), GMA (25.1 g), AN (50.0 g), TMPS (12.6 g), M-140 (50.4 g), and acetone (200.7 g). An initiator solution was prepared by combining 1.2522 g of Vazo®-52 and 26.2527 g of acetone. The monomer premix and initiator solution were dispensed via a pump through a septum and an addition tube, respectively, connected to a Claisen adaptor which was attached to a 4-neck, one L, round bottom flask heated to 75ºC via an oil bath and equipped with an overhead stirrer, water-jacketed condenser, and thermocouple. To the one L round bottom flask was added 47.77 g of the monomer premix, which was stirred at 200 rpm for five minutes. This was followed by addition of -3 mL of the initiator stock solution and heating for 20 minutes at reflux. The remaining monomer premix and Initiator solution were co-slow added to the one L round bottom flask (reflux, 200 rpm) over the course of two hours 1 minutes and two hours 50 minutes, respectively. The contents were stirred for an additional four hours at reflux then cooled overnight. A scavenger solution prepared from 2.6082 g of 75% *t*-amyl peroxypivalate in mineral spirits dissolved In 25.8726 g of acetone was slow added to the flask at reflux over two hours followed by heating an additional one hour. At the end of the hold, a modified Dean-Stark trap was attached to the flask and acetone was removed while slowly adding carbitol acetate to maintain manageable viscosity.

The title polymer was obtained as a clear, slightly yellow polymer solution (485.2 g) at 48.8% solids. Molecular weight was determined via GPC using THF as the mobile phase and polystyrene standards to give $M_n$=31,753 g/mol, $M_w$=77,221 g/mol, and PDI=2.43. Glass transition temperature was determined as 15.8ºC on second heat via a TA Instruments Q100 modulated DSC heating from room temperature to 110ºC at 10ºC/minute, followed by a rapid cool to -90ºC, then a second heat from -90ºC to 110ºC at 10ºC/minute. Viscosity was determined as 7536 cP on a Brookfield cone and plate viscometer using Spindle 51 at 50ºC and 5.0 rpm at 45% solids. Comonomer incorporation was determined

via C-13 NMR in deuterated chloroform to give (by weight) 47% nBA, 9% GMA, 19% AN, 7% TMPS, and 18% M-140.

EXAMPLE 26: PREPARATION AND CHARACTERIZATION OF POLY(N-BA-*co*-GMA-*co*-AN-*co*-TMPS-*co*-M-140): In a one L Erlenmeyer flask, a monomer premix was prepared by combining nBA (137.7 g), GMA (25.3 g), AN (50.8 g), TMPS (12.6 g), M-140 (25.0 g), and acetone (200.1 g). An initiator solution was prepared by combining 1.2670 g of Vazo®-52 and 25.9970 g of acetone. The monomer premix and initiator solution were dispensed via a pump through a septum and an addition tube, respectively, connected to a Claisen adaptor which was attached to a 4-neck, one L, round bottom flask heated to 75ºC via an oil bath and equipped with an overhead stirrer, water-jacketed condenser, and thermocouple. To the one L round bottom flask was added 46.75 g of the monomer premix, which was stirred at 200 rpm for five minutes. This was followed by addition of -3 mL of the initiator stock solution and heating for 23 minutes at reflux. The remaining monomer premix and initiator solution were co-slow added to the one L round bottom flask (reflux, 200 rpm) over the course of one hour 53 minutes and two hours 57 minutes, respectively. The contents were stirred for an additional four hours at reflux then cooled overnight. A scavenger solution prepared from 2.5749 g of 75% *t*-amyl peroxypivalate in mineral spirits dissolved in 25.2581 g of acetone was slow added to the flask at reflux over two hours followed by heating an additional one hour. At the end of the hold, a modified Dean-Stark trap was attached to the flask and acetone was removed while slowly adding carbitol acetate to maintain manageable viscosity.

The title polymer was obtained as a clear, slightly yellow polymer solution (496.7 g) at 47.8% solids. Molecular weight was determined via GPC using THF as the mobile phase and polystyrene standards to give $M_n$=37,054 g/mol, $M_w$=81,478 g/mol, and PDI=2.20. Glass transition temperature was determined as 11.6ºC on second heat via a TA Instruments Q100 modulated DSC heating from room temperature to 110ºC at 10ºC/minute, followed by a rapid cool to -90ºC, then a second heat from -90ºC to 110ºC at 10ºC/minute. Viscosity was determined as 7209 cP on a Brookfield cone and plate viscometer using Spindle 51 at 50ºC and 5.0 rpm at 45% solids. Comonomer incorporation was determined via C-13 NMR in deuterated chloroform to give (by weight) 59% nBA, 8% GMA, 19% AN, 7% TMPS, and 7% M-140.

EXAMPLE 27: PREPARATION AND CHARACTERIZATION OF POLY(N-BA-*co*-GMA-*co*-AN-*co*-TMPS-*co*-M-140): In a one L Erlenmeyer flask, a monomer premix was prepared by combining nBA (87.6 g), GMA (25.5 g), AN (50.6 g), TMPS (12.6 g), M-140 (72.5 g), and acetone (201.3 g). An initiator solution was prepared by combining 1.2613 g of Vazo®-52 and 25.8864 g of acetone. The monomer premix and initiator solution were dispensed via a pump through a septum and an addition tube, respectively, connected to a Claisen adaptor which was attached to a 4-neck, one L round bottom flask heated to 75ºC via an oil bath and equipped with an overhead stirrer, water-jacketed condenser, and thermocouple. To the one L round bottom flask was added 46.60 g of the monomer premix, which was stirred at 200 rpm for five minutes. This was followed by addition of ~three mL of the initiator stock solution and heating for 20 minutes at reflux. The remaining monomer premix and initiator solution were co-slow added to the one L round bottom flask (reflux, 200 rpm) over the course of one hour 50 minutes and two hours 57 minutes, respectively. The contents were stirred for an additional four hours at reflux then cooled overnight. A scavenger solution prepared from 2.5176 g of 75% *t*-amyl peroxypivalate in mineral spirits dissolved in 25.0719 g of acetone was slow added to the flask at reflux over two hours followed by heating an additional one hour. At the end of the hold, a modified Dean-Stark trap was attached to the flask and acetone was removed while slowly adding carbitol acetate to maintain manageable viscosity.

The title polymer was obtained as a clear, slightly yellow polymer solution (483.7 g) at 51.4% solids. Molecular weight was determined via GPC using THF as the mobile phase and polystyrene standards to give $M_n$=33,518 g/mol, $M_w$=79,844 g/mol, and PDI=2.38. Glass transition temperature was determined as 18.8ºC on second heat via a TA Instruments Q100 modulated DSC heating from room temperature to 110ºC at 10ºC/minute, followed by a rapid cool to -90ºC, then a second heat from -90ºC to 110ºC at 10ºC/minute. Viscosity was determined as 6717 cP on a Brookfield cone and plate viscometer using Spindle 51 at 50ºC and 5.0 rpm at 45% solids. Comonomer incorporation was determined via C-13 NMR in deuterated chloroform to give (by weight) 41% nBA, 8% GMA, 20% AN, 7% TMPS, and 24% M-140.

Examples 28-29 describe the preparation of the polymer containing the general structure shown below with and without acrylonitrile (i.e. when c>0% and c=0%):

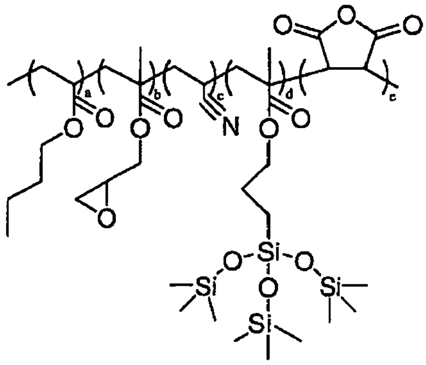

EXAMPLE 28: PREPARATION AND CHARACTERIZATION OF POLY(N-BA-*co*-GMA-*co*-TMPS-*co*-MALEIC ANHYDRIDE): In a one L Erlenmeyer flask, a monomer premix was prepared by combining nBA (162.7 g), GMA (25.2 g), TMPS (12.6 g), and acetone (160.2 g). An initiator solution was prepared by combining 1.2544 g of Vazo®-52 and 25.0492 g of acetone. The monomer premix and initiator solution were dispensed via a pump through a septum and an addition tube, respectively, connected to a Claisen adaptor which was attached to a 4-neck, one L, round bottom flask heated to 75ºC via an oil bath and equipped with an overhead stirrer, water-jacketed condenser, and thermocouple. To the one L round bottom flask was added maleic anhydride (MA, 50.0 g), acetone (41.1 g), and 36.5 g of the monomer premix, which was stirred at 200 rpm for five minutes. This was followed by addition of ~3 mL of the initiator stock solution and heating for 22 minutes at reflux. The remaining monomer premix and initiator solution were co-slow added to the one L round bottom flask (reflux, 200 rpm) over the course of one hour 58 minutes and three hours 3 minutes, respectively. The orange solution was stirred for an additional four hours at reflux then cooled overnight. A scavenger solution prepared from 2.5668 g of 75% *t*-amyl peroxypivalate in mineral spirits dissolved in 25.1559 g of acetone was slow added to the flask at reflux over two hours followed by heating an additional one hour. At the end of the hold, a modified Dean-Stark trap was attached to the flask and acetone was removed while slowly adding carbitol acetate to maintain manageable viscosity.

The title polymer was obtained as a clear, orange polymer solution (487.2 g) at 47.7% solids. Molecular weight was determined via GPC using THF as the mobile phase and polystyrene standards to give $M_n$=25,395 g/mol, $M_w$=731,216 g/mol, and PDI=28.79. Glass transition temperature was determined as 6.1ºC on second heat via a TA Instruments Q100 modulated DSC heating from room temperature to 110ºC at 10ºC/minute, followed by a rapid cool to -90ºC, then a second heat from -90ºC to 110ºC at 10 ºC/minute. Viscosity was determined as 5570 cP on a Brookfield cone and plate viscometer using Spindle 51 at 50ºC and 5.0 rpm at 45% solids.

EXAMPLE 29: PREPARATION AND CHARACTERIZATION OF POLY(N-BA-*co*-GMA-*co*-AN-*co*-TMPS-*co*-MA): In a one L Erlenmeyer flask, a monomer premix was prepared by combining nBA (112.6 g), GMA (25.1 g), AN (50.6 g), TMPS (12.7 g), and acetone (160.2 g). An initiator solution was prepared by combining 1.2476 g of Vazo®-52 and 24.9369 g of acetone. The monomer premix and Initiator solution were dispensed via a pump through a septum and an addition tube, respectively, connected to a Claisen adaptor which was attached to a 4-neck, one L, round bottom flask heated to 75ºC via an oil bath and equipped with an overhead stirrer, water-jacketed condenser, and thermocouple. To the one L round bottom flask was added MA (50.1 g), acetone (40.9 g), and 37.1 g of the monomer premix, which was stirred at 200 rpm for five minutes. This was followed by addition of ~3 mL of the initiator stock solution and heating for 23 minutes at reflux. The remaining monomer premix and initiator solution were co-slow added to the one L round bottom flask (reflux, 200 rpm) over the course of one hour 57 minutes and three hours 12 minutes, respectively. The red solution was stirred for an additional four hours at reflux then cooled overnight. A scavenger solution prepared from 2.601 g of 75% *t*-amyl peroxypivalate in mineral spirits dissolved in 26.0479 g of acetone was slow added to the flask at reflux over two hours followed by heating an additional one hour. At the end of the hold, a modified Dean-Stark trap was attached to the flask and acetone was removed while slowly adding carbitol acetate to maintain manageable viscosity.

The title polymer was obtained as a clear, red polymer solution (496.9 g) at 39.7% solids. Molecular weight was determined via GPC using THF as the mobile phase and polystyrene standards to give $M_n$=10,956 g/mol, $M_w$=968,841 g/mol, and PDI=89.14. Glass transition temperature was determined as 35.4ºC on second heat via a TA Instruments Q100 modulated DSC heating from room temperature to 110ºC at 10ºC/minute, followed by a rapid cool to -90ºC, then a second heat from -90ºC to 110ºC at 10ºC/minute.

Examples 30-32 describe the preparation of the polymer containing the general structure shown below with various levels of the different monomers:

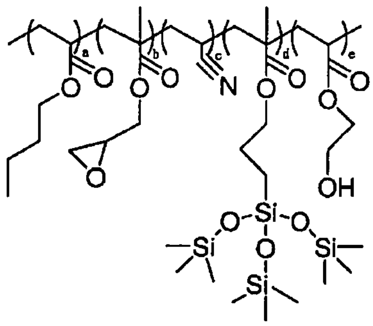

EXAMPLE 30: PREPARATION AND CHARACTERIZATION OF POLY(N-BA-*co*-GMA-*co*-AN-*co*-TMPS-*co*-HYDROXYVETHYL ACRYLATE): A monomer premix was prepared by combining nBA (112.5 g), GMA (25 g), AN (50 g), TMPS (12.5 g), and hydroxyethyl acrylate (HEA, 50 g). An initial charge of monomer premix (37.5 g), acetone (25 g) and AIBN (0.19 g) were added to a 2 L, 4-neck, round bottom flask equipped with a stainless steel stirrer, thermometer, addition funnel, and condenser. The initial charge was heated to reflux while stirring and held at that temperature for 15 minutes. To the remaining monomer premix was added acetone (15 g). An initiator solution was prepared by combining AIBN (2.4 g) and acetone (185 g). The monomer premix and initiator solutions were slow added over two hours and three hours, respectively, while maintaining reflux. At the end of the addition, the flask contents were stirred for three hours while maintaining reflux, then cooled overnight. To the flask at reflux, a scavenger solution (2.5 g *t*-amyl peroxypivalate and 25 g acetone) was added over two hours and held at reflux for one hour while stirring. At the end of the hold, a modified Dean-Stark trap was attached to the flask and acetone was removed while slowly adding carbitol acetate to maintain manageable viscosity. Distillation was continued until no further distillate was removed at 110°C after 30 minutes.

The title polymer was obtained as a clear, dark yellow solution at 48.2% solids. Molecular weight was determined via GPC using THF as the mobile phase and polystyrene standards to give $M_n$=44,512 g/mol, $M_w$=181,257 g/mol, and PDI=4.10. Glass transition temperature was determined as 3.7ºC on second heat via a TA Instruments Q100 modulated DSC heating from room temperature to 110ºC at 10ºC/minute, followed by a rapid cool to -90ºC, then a second heat from -90ºC to 110ºC at 10ºC/minute. Viscosity was determined as 18,020 cP on a Brookfield cone and plate viscometer using Spindle 51 at 50ºC and 5.0 rpm at 45% solids.

EXAMPLE 31: PREPARATION AND CHARACTERIZATION OF POLY(N-BA-*co*-GMA-*co*-AN-*co*-TMPS-*co*-HEA): A monomer premix was prepared by combining nBA (137.5 g), GMA (25 g), AN (50 g), TMPS (12.5 g), and HEA (25 g). An initial charge of monomer premix (37.5 g), acetone (25 g) and AIBN (0.19 g) were added to a 2 L, 4-neck, round bottom flask equipped with a stainless steel stirrer, thermometer, addition funnel, and condenser. The initial charge was heated to reflux while stirring and held at that temperature for 15 minutes. To the remaining monomer premix was added acetone (15g). An initiator solution was prepared by combining AIBN (2.4 g) and acetone (185 g). The monomer premix and initiator solutions were slow added over two hours and three hours, respectively, while maintaining reflux. At the end of the addition, the flask contents were stirred for three hours while maintaining reflux, then cooled overnight. To the flask at reflux, a scavenger solution (2.5 g *t*-amyl peroxypivalate and 25 g acetone) was added over two hours and held at reflux for one hour while stirring. At the end of the hold, a modified Dean-Stark trap was attached to the flask and acetone was removed while slowly adding carbitol acetate to maintain manageable viscosity. Distillation was continued until no further distillate was removed at 110°C after 30 minutes.

The title polymer was obtained as a clear, dark yellow solution at 48.8% solids. Molecular weight was determined via GPC using THF as the mobile phase and polystyrene standards to give $M_n$=42,851 g/mol, $M_w$=126,439 g/mol, and PDI=2.95. Glass transition temperature was determined as 0.2ºC on second heat via a TA Instruments Q100 modulated DSC heating from room temperature to 110ºC at 10ºC/minute, followed by a rapid cool to -90ºC, then a second heat from -90ºC to 110ºC at 10ºC/minute. Viscosity was determined as 6,881 cP on a Brookfield cone and plate viscometer using Spindle 51 at 50ºC and 5.0 rpm at 45% solids. Comonomer incorporation was determined via C-13 NMR in deuterated chloroform to give (by weight) 60% nBA, 8% GMA, 18% AN, 8% TMPS, and 6% HEA.

EXAMPLE 32: PREPARATION AND CHARACTERIZATION OF POLY(N-BA-*co*-GMA-*co*-AN-*co*-TMPS-*co*-HEA): A monomer premix was prepared by combining nBA (87.5 g), GMA (25 g), AN (50 g), TMPS (12.5 g), and HEA (75 g). An initial charge of monomer premix (37.5 g), acetone (25 g) and AIBN (0.19 g) were added to a 2 L, 4-neck, round bottom flask equipped with a stainless steel stirrer, thermometer, addition funnel, and condenser. The initial charge was heated to reflux while stirring and held at that temperature for 15 minutes. To the remaining monomer premix was added acetone (15 g). An initiator solution was prepared by combining AIBN (2.4 g) and acetone (185 g). The monomer premix and initiator solutions were slow added over two hours and three hours, respectively, while maintaining

reflux. At the end of the addition, the flask contents were stirred for three hours while maintaining reflux, then cooled overnight. To the flask at reflux, a scavenger solution (2.5 g *t*-amyl peroxypivalate and 25 g acetone) was added over two hours and held at reflux for one hour while stirring. At the end of the hold, a modified Dean-Stark trap was attached to the flask and acetone was removed while slowly adding carbitol acetate to maintain manageable viscosity. Distillation was continued until no further distillate was removed at 110°C after 30 minutes.

The title polymer was obtained as a clear, yellow solution at 45.2% solids. Molecular weight was determined via GPC using THF as the mobile phase and polystyrene standards to give $M_n$=59,446 g/mol, $M_W$=531,863 g/mol, and PDI=8.95. Glass transition temperature was determined as -five.4 ºC on second heat via a TA Instruments Q100 modulated DSC heating from room temperature to 110ºC at 10ºC/minute, followed by a rapid cool to -90ºC, then a second heat from -90ºC to 110ºC at 10ºC/minute. Viscosity was determined as 36,040 cP on a Brookfield cone and plate viscometer using Spindle 51 at 50ºC and 5.0 rpm at 45% solids.

Examples 33-36 describe the preparation of the polymer containing the general structure shown below with and without acrylonitrile (i.e. when c>0% and c=0%) at various levels of the different monomers:

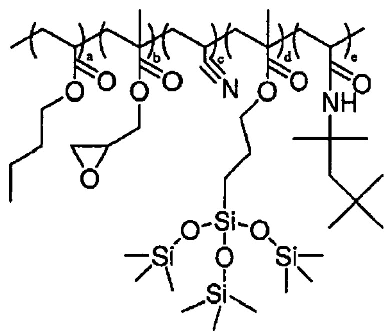

EXAMPLE 33: PREPARATION AND CHARACTERIZATION OF POLY(*N*-BA-*co*-GMA-*co*-TMPS-*co*-T-OCTYL ACRYLAMIDE): A monomer premix was prepared by combining nBA (112.5 g), GMA (25 g), TMPS (12.5 g), *t*-octyl acrylamide (tOA, 100 g), and acetone (10g). An initial charge of monomer premix (37.5 g), acetone (25 g) and AIBN (0.19 g) were added to a 2 L, 4-neck, round bottom flask equipped with a stainless steel stirrer, thermometer, addition funnel, and condenser. The initial charge was heated to reflux while stirring and held at that temperature for 15 minutes. To the remaining monomer premix was added acetone (15 g). An initiator solution was prepared by combining AIBN (2.4 g) and acetone (185 g). The monomer premix and initiator solutions were slow added over two hours and three hours, respectively, while maintaining reflux. At the end of the addition, the flask contents were stirred for three hours while maintaining reflux, then cooled overnight. To the flask at reflux, a scavenger solution (2.5 g *t*-amyl peroxypivalate and 25 g acetone) was added over two hours and held at reflux for one hour while stirring. At the end of the hold, a modified Dean-Stark trap was attached to the flask and acetone was removed while slowly adding carbitol acetate to maintain manageable viscosity. Distillation was continued until no further distillate was removed at 110°C after 30 minutes.

The title polymer was obtained as a clear, colorless solution at 52.0% solids. Molecular weight was determined via GPC using THF as the mobile phase and polystyrene standards to give $M_n$=57,944 g/mol, $M_w$=346,830 g/mol, and PDI=6.02. Glass transition temperature was determined as 2.0 °C on second heat via a TA Instruments Q100 modulated DSC heating from room temperature to 110ºC at 10ºC/minute, followed by a rapid cool to -90ºC, then a second heat from -90ºC to 110ºC at 10ºC/minute. Viscosity was determined as 10,320 cP on a Brookfield cone and plate viscometer using Spindle 51 at 50ºC and 5.0 rpm at 45% solids. Comonomer incorporation was determined via C-13 NMR in deuterated chloroform to give (by weight) 54% nBA, 8% GMA, 6% TMPS, and 32% tOA.

EXAMPLE 34: PREPARATION AND CHARACTERIZATION OF POLY(N-BA-*co*-GMA-*co*-AN-*co*-TMPS-*co*-T-OA): A monomer premix was prepared by combining nBA (112.5 g), GMA (25 g), TMPS (12.5 g), AN (50 g), tOA (50 g), and acetone (10g). An initial charge of monomer premix (37.5 g), acetone (25 g) and AIBN (0.19 g) were added to a 2 L, 4-neck, round bottom flask equipped with a stainless steel stirrer, thermometer, addition funnel, and condenser. The initial charge was heated to reflux while stirring and held at that temperature for 15 minutes. To the remaining monomer premix was added acetone (15 g). An initiator solution was prepared by combining AIBN (2.4 g) and acetone (185 g). The monomer premix and initiator solutions were slow added over two hours and three hours, respectively, while maintaining reflux. At the end of the addition, the flask contents were stirred for three hours while maintaining reflux, then cooled overnight. To the flask at reflux, a scavenger solution (2.5 g *t*-amyl peroxypivalate and 25 g acetone) was added over two hours and held at reflux for one hour while stirring. At the end of the hold, a modified Dean-Stark trap was attached to the flask and acetone was removed while slowly adding carbitol acetate to maintain manageable viscosity. Distillation was continued until no further distillate was removed at 110°C after 30 minutes.

The title polymer was obtained as a clear, light yellow solution at 51.9% solids. Molecular weight was determined via GPC using THF as the mobile phase and polystyrene standards to give $M_n$=29,503 g/mol, $M_w$=88,840 g/mol, and PDI=3.02. Glass transition temperature was determined as 18.3ºC on second heat via a TA Instruments Q100 modulated DSC heating from room temperature to 110ºC at 10ºC/minute, followed by a rapid cool to -90ºC, then a second heat from -90ºC to 110ºC at 10ºC/minute. Viscosity was determined as 5,079 cP on a Brookfield cone and plate viscometer using Spindle 51 at 50ºC and 5.0 rpm at 45% solids. Comonomer incorporation was determined via C-13 NMR in deuterated chloroform to give (by weight) 52% nBA, 8% GMA, 18% AN, 7% TMPS, and 15% tOA.

EXAMPLE 35: PREPARATION AND CHARACTERIZATION OF POLY(N-BA-*co*-GMA-*co*-AN-*co*-TMPS-*co*-T-OA): A monomer premix was prepared by combining nBA (137.5 g), GMA (25 g), TMPS (12.5 g), AN (50 g), tOA (25 g), and acetone (10g). An initial charge of monomer premix (37.5 g), acetone (25 g) and AIBN (0.19 g) were added to a 2 L, 4-neck, round bottom flask equipped with a stainless steel stirrer, thermometer, addition funnel, and condenser. The initial charge was heated to reflux while stirring and held at that temperature for 15 minutes. To the remaining monomer premix was added acetone (15 g). An initiator solution was prepared by combining AIBN (2.4 g) and acetone (185 g). The monomer premix and initiator solutions were slow added over two hours and three hours, respectively, while maintaining reflux. At the end of the addition, the flask contents were stirred for three hours while maintaining reflux, then cooled overnight. To the flask at reflux, a scavenger solution (2.5 g *t*-amyl peroxypivalate and 25 g acetone) was added over two hours and held at reflux for one hour while stirring. At the end of the hold, a modified Dean-Stark trap was attached to the flask and acetone was removed while slowly adding carbitol acetate to maintain manageable viscosity. Distillation was continued until no further distillate was removed at 110°C after 30 minutes.

The title polymer was obtained as a clear, yellow solution at 52.8% solids. Molecular weight was determined via GPC using THF as the mobile phase and polystyrene standards to give $M_n$=35,342 g/mol, $M_w$=90,066 g/mol, and PDI=2.56. Glass transition temperature was determined as five.1ºC on second heat via a TA Instruments Q100 modulated DSC heating from room temperature to 110ºC at 10ºC/minute, followed by a rapid cool to -90ºC, then a second heat from -90ºC to 110ºC at 10ºC/minute. Viscosity was determined as 3,031 cP on a Brookfield cone and plate viscometer using Spindle 51 at 50ºC and 5.0 rpm at 45% solids. Comonomer incorporation was determined via C-13 NMR in deuterated chloroform to give (by weight) 58% nBA, 8% GMA, 18% AN, 8% TMPS, and 8% tOA.

EXAMPLE 36: PREPARATION AND CHARACTERIZATION OF POLY(N-BA-*co*-GMA-*co*-TMPS-*co*-T-OA): A monomer premix was prepared by combining nBA (162.5 g), GMA (25 g), TMPS (12.5 g), tOA (50 g), and acetone (10g). An initial charge of monomer premix (37.5 g), acetone (25 g) and AIBN (0.19 g) were added to a 2 L, 4-neck, round bottom flask equipped with a stainless steel stirrer, thermometer, addition funnel, and condenser. The initial charge was heated to reflux while stirring and held at that temperature for 15 minutes. To the remaining monomer premix was added acetone (15g). An initiator solution was prepared by combining AIBN (2.4 g) and acetone (185g). The monomer premix and initiator solutions were slow added over two hours and three hours, respectively, while maintaining reflux. At the end of the addition, the flask contents were stirred for three hours while maintaining reflux, then cooled overnight. To the flask at reflux, a scavenger solution (2.5 g *t*-amyl peroxypivalate and 25 g acetone) was added over two hours and held at reflux for one hour while stirring. At the end of the hold, a modified Dean-Stark trap was attached to the flask and acetone was removed while slowly adding carbitol acetate to maintain manageable viscosity. Distillation was continued until no further distillate was removed at 110°C after 30 minutes.

The title polymer was obtained as a clear, colorless solution at 50.1 % solids. Molecular weight was determined via GPC using THF as the mobile phase and polystyrene standards to give $M_n$=70,770 g/mol, $M_w$=389,738 g/mol, and PDI=five.53. Glass transition temperature was determined as -21.4 °C on second heat via a TA Instruments Q100 modulated DSC heating from room temperature to 110ºC at 10ºC/minute, followed by a rapid cool to -90ºC, then a second heat from -90ºC to 11ºC at 10ºC/minute. Viscosity was determined as 14,910 cP on a Brookfield cone and plate viscometer using Spindle 51 at 50 °C and 5.0 rpm at 45% solids. Comonomer incorporation was determined via C-13 NMR in deuterated chloroform to give (by weight) 70% nBA, 8% GMA, 6% TMPS, and 16% tOA.

Examples 37-38 describe the preparation of the polymer containing the general structure shown below with and without acrylonitrile (i.e. when c>0% and c=0%);

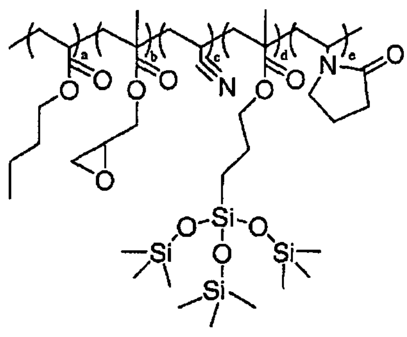

EXAMPLE 37: PREPARATION AND CHARACTERIZATION OF POLY(N-BA-*co*-GMA-*co*-TMPS-*co*-N-VINYL PYRROLIDONE): A monomer premix was prepared by combining nBA (162.5 g), GMA (25 g), TMPS (12.5 g), and N-vinyl pyrrolidone (NVP, 50 g). An initial charge of monomer premix (37.5 g), acetone (25 g) and AIBN (0.19 g) were added to a 2 L, 4-neck, round bottom flask equipped with a stainless steel stirrer, thermometer, addition funnel, and condenser. The initial charge was heated to reflux while stirring and held at that temperature for 15 minutes. To the remaining monomer premix was added acetone (15 g). An Initiator solution was prepared by combining AIBN (2.4 g) and acetone (185 g). The monomer premix and initiator solutions were slow added over two hours and three hours, respectively, while maintaining reflux. At the end of the addition, the flask contents were stirred for three hours while maintaining reflux, then cooled overnight. To the flask at reflux, a scavenger solution (2.5 g *t*-amyl peroxypivalate and 25 g acetone) was added over two hours and held at reflux for one hour while stirring. At the end of the hold, a modified Dean-Stark trap was attached to the flask and acetone was removed while slowly adding carbitol acetate to maintain manageable viscosity. Distillation was continued until no further distillate was removed at 110°C after 30 minutes.

The title polymer was obtained as a clear, light yellow solution at 51.6% solids. Molecular weight was determined via GPC using THF as the mobile phase and polystyrene standards to give $M_n$=98,975 g/mol, $M_w$=407,532 g/mol, and PDI=4.15. Glass transition temperature was determined as -1.3ºC on second heat via a TA Instruments Q100 modulated DSC heating from room temperature to 110ºC at 10ºC/minute, followed by a rapid cool to -90ºC, then a second heat from -90ºC to 110ºC at 10ºC/minute. Viscosity was determined as 80,280 cP on a Brookfield cone and plate viscometer using Spindle 51 at 50ºC and 5.0 rpm at 45% solids.

EXAMPLE 38: PREPARATION AND CHARACTERIZATION OF POLY(N-BA-*co*-GMA-*co*-AN-*co*-TMPS-*co*-NVP): A monomer premix was prepared by combining nBA (112.5 g), GMA (25 g), AN (50 g), TMPS (12.5 g), and NVP (50 g). An initial charge of monomer premix (37.5 g), acetone (25 g) and AIBN (0.19 g) were added to a 2 L, 4-neck, round bottom flask equipped with a stainless steel stirrer, thermometer, addition funnel, and condenser. The initial charge was heated to reflux while stirring and held at that temperature for 15 minutes. To the remaining monomer premix was added acetone (15g). An initiator solution was prepared by combining AIBN (2.4 g) and acetone (185g). The monomer premix and initiator solutions were slow added over two hours and three hours, respectively, while maintaining reflux. At the end of the addition, the flask contents were stirred for three hours while maintaining reflux, then cooled overnight. To the flask at reflux, a scavenger solution (2.5 g *t*-amyl peroxypivalate and 25 g acetone) was added over two hours and held at reflux for one hour while stirring. At the end of the hold, a modified Dean-Stark trap was attached to the flask and acetone was removed while slowly adding carbitol acetate to maintain manageable viscosity. Distillation was continued until no further distillate was removed at 110°C after 30 minutes.

The title polymer was obtained as a hazy, yellow solution at 53.4% solids. Molecular weight was determined via GPC using THF as the mobile phase and polystyrene standards to give $M_n$=58,417 g/mol, $M_w$=144,670 g/mol, and PDI=2.48. Glass transition temperature was determined as 42.7ºC on second heat via a TA Instruments Q100 modulated DSC heating from room temperature to 110ºC at 10ºC/minute, followed by a rapid cool to -90ºC, then a second heat from -90ºC to 110ºC at 10ºC/minute. Viscosity was determined as 23,250 cP on a Brookfield cone and plate viscometer using Spindle 51 at 50ºC and 5.0 rpm at 45% solids.

EXAMPLE 39 PERMEATION COEFFICIENTS: The water vapor transmission rate (WVTR) values were measured at 25°C and 100% relative humidity on a Mocon Permatran-W3/31 using 1 $cm^2$ portions of film isolated from Examples 1, 2, and CTBN elastomer adduct. Normalizing the WVTR to film thickness gives the permeation coefficient values that are shown in Table 1. Higher permeation coefficients indicate higher permeability of the material.

| TABLE 1. PERMEATION COEFFICIENTS OF SILOXANE ACRYLIC, ACRYLIC, AND CTBN-ADDUCT POLYMERS | |
|---|---|
| | Permeation Coefficient [mil•gram/($m^2$•day)] |
| Siloxane acrylic polymer from example 1 | 2021 |
| Acrylic polymer from example 2 | 1246 |
| CTBN adduct | 226 |

EXAMPLE 40. VOIDING AND DIE SHEAR STRENGTH PERFORMANCE. Three formulations, designated A, B, and C In Table 2, were prepared to test voiding, die shear strength, and tackiness. The polymers from Example 13 and 16 were utilized in Formulations A and B, respectively. A carboxy-terminated butadiene acrylonitrile (CTBN) Rubber Adduct was utilized In Formulation C. All three formulations used similar amounts of rubber as well as fillers, thermoset, and additives.

| TABLE 2: FORMULATIONS PREPARED TO TEST VOIDING, DIE SHEAR STRENGTH, AND TACKINESS | | | |
|---|---|---|---|
| COMPONENT | FORMULATION A | FORMULATION B | FORMULATION C |
| Polymer from Example 13 | 47.2 | - | - |
| Polymer from Example 15 | - | 47.2 | - |
| CTBN Rubber Adduct | - | - | 47.2 |
| Thermoset and Additives | 20.3 | 20.3 | 20.3 |
| Fillers | 32.5 | 32.5 | 32.5 |
| Total | 100 | 100 | 100 |

The results of the performance testing for each formulation are denoted in Table 3. To test for tackiness, each formulation was stencil printed onto a BT (laminate) substrate followed by heating for 90 min at 110ºC. Tackiness of the b-staged formulation was determined by a simple test where finger pressure was applied to the b-staged formulation and then removed. If adherence of the finger to the substrate was noted, the material was denoted as ''Tacky,'' otherwise, the material was denoted as "Tack-free."

Voiding was determined by attaching a glass slide using 1.5 kg of pressure at 140ºC to the b-staged material after remaining at ambient conditions for one day. Curing was done in an oven with a 30 min ramp from 25ºC to 90ºC, a 60 min hold at 90ºC, a 30 min ramp from 90 °C to 175ºC, and a final 60 min hold at 175ºC. After the sample had cooled, voiding was determined by visual examination of the material under the glass slide.

To test for green strength, a 200 x 200 mil silicon die was attached to the b-staged formulation using 1.5 kg of pressure at 140ºC. The die was then sheared at 90 degrees from the substrate using a Dage 2400-PC Die Shear Tester, at room temperature. The force needed to shear the die is formulation dependent as reported in Table 3.

To test for die shear strength (DSS) at 25 °C and 260 °C a 200 x 200 mil silicon die was attached to the b-staged formulation using 1.5 kg of pressure at 140ºC. Curing was done in an oven with a 30 min ramp from 25ºC to 90ºC, a 60 min hold at 90ºC, a 30 min ramp from 90ºC to 175ºC, and a final 60 min hold at 175ºC. After the sample had cooled the die was then sheared at 90 degrees from the substrate using a Dage 2400-PC Die Shear Tester at 25 °C and 260 °C. The force needed to shear the die is formulation dependent as reported in Table 3.

| TABLE 3: PERFORMANCE TESTING OF FORMULATIONS A, B, AND C. | | | |
|---|---|---|---|
| PERFORMANCE | A | B | C |
| TACKINESS | TACK-FREE | TACK-FREE | TACKY |
| VOIDING | EXTREMELY LOW | EXTREMELY LOW | HIGH |
| GREEN STRENGTH (KG) | 8.5 | 14.1 | 4.9 |
| DSS AT 25ºC (KG) | 25.5 | 27.6 | 36.7 |
| DSS AT 260ºC (KG) | 1.8 | 2.3 | 1.4 |

Formulations A and B, containing the inventive polymers, had superior voiding, tackiness, and green strength performance as compared with Formulation C, which contained the comparative material.

## Claims

1. A polymer comprising a polymeric backbone and pendant from the backbone:

   a. at least one siloxane moiety, and
   b. at least one reactive moiety capable of reacting to form a new covalent bond,

   **characterized in that** the polymer is prepared by the reaction of one or more monomers that contain at least one carbon to carbon double bond and at least one siloxane moiety, and one or more monomers that contain at least one carbon to carbon double bond and at least one reactive moiety capable of reacting to form a new covalent bond.

2. The polymer according to claim 1 further comprising one or more pendant moieties that impart at least one of the following functionalities or properties:

   (i) low glass transition temperature,
   (ii) high glass transition temperature,
   (iii) adhesion.

3. The polymer according to claim 1 in which the pendant siloxane moiety is added to the polymeric backbone by the reaction of monomers selected from the group consisting of

   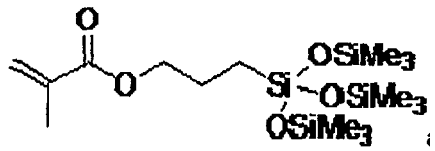

   and

   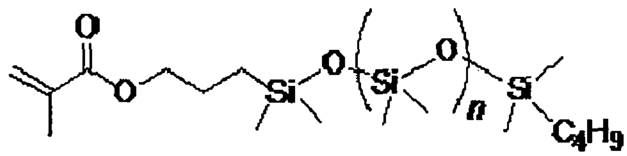

   in which n is 1 to 100 and both of them.

4. The polymer according to claim 2 in which the monomers that impart iow Tg are selected from the group consisting of alkyl acrylates and alkyl methacrylates.

5. The polymer according to claim 4 in which the monomers are selected from the group consisting of butyl acrylate, amyl acrylate, hexyl acrylate, 2-ethylhexyl acrylate, isooctyl acrylate, decyl acrylate, dodecyl acrylates, isomers thereof, and combinations thereof.

6. The polymer according to claim 2 in which the monomers that impart high Tg are selected from the group consisting of methyl acrylate, ethyl acrylate, isobutyl acrylate, vinyl acetate, methyl methacrylate, isobutyl methacrylate, vinyl pyrrolidone, substituted acrylamides, substituted methacrylamides, acrylonitriles, maleic anhydride, and combinations of those.

7. The polymer according to claim 1 in which the monomers that contain at least one reactive moiety are compounds containing both a reactive carbon to carbon double bond and an epoxy, oxetane, oxazoline, benzoxazine, or episulfide

functionality.

8. The polymer according to claim 7 in which the monomers that contain at least one reactive moiety are selected from the group consisting of:

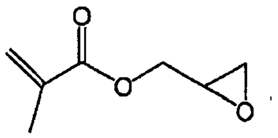

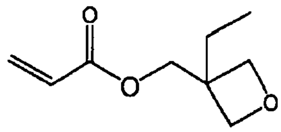

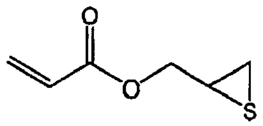

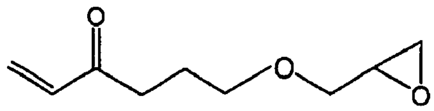

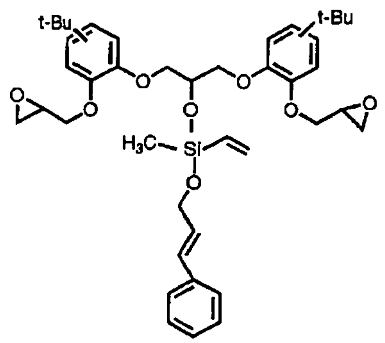

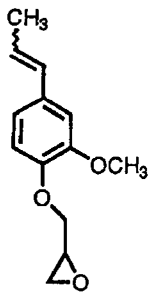

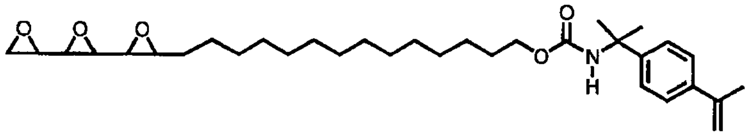

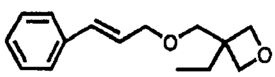

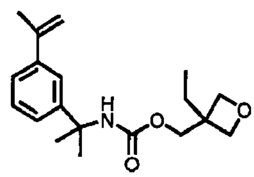

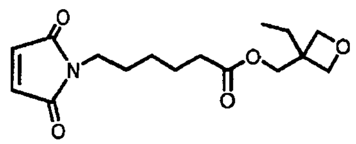

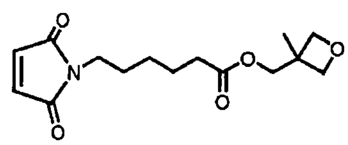

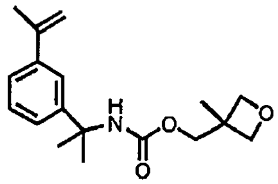

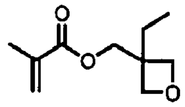

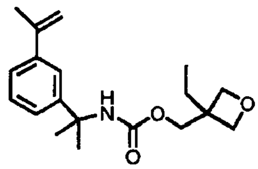

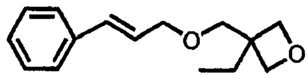

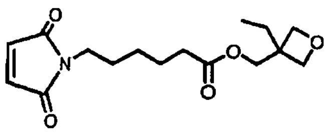

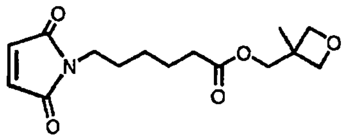

and

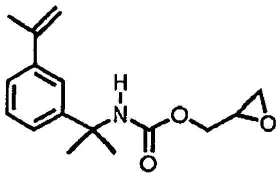

.

**9.** The polymer according to claim 2 in which the monomers that impart adhesion are selected from the group consisting of

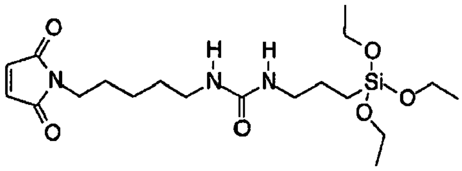

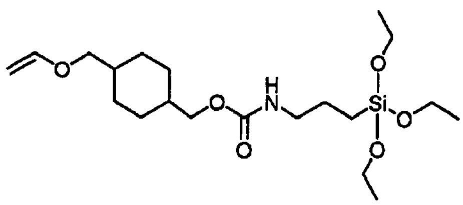

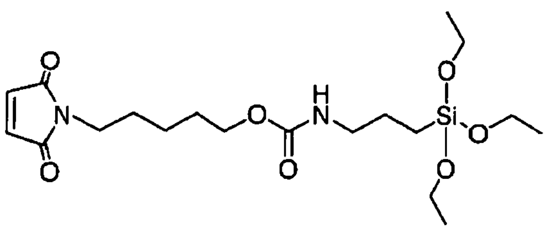

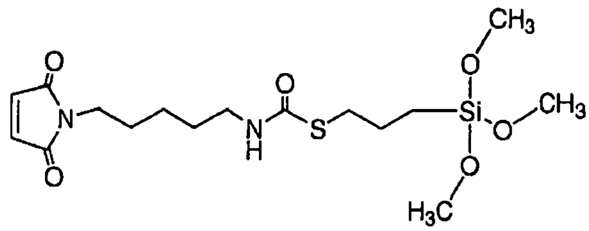

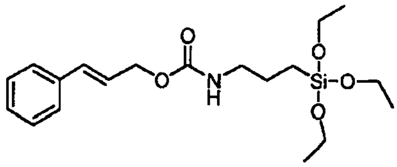

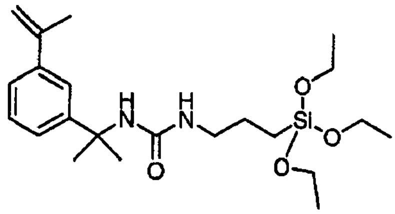

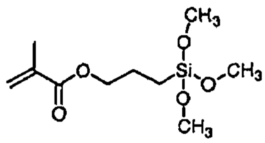

and compounds having the generic structures:

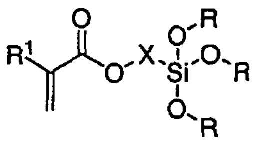

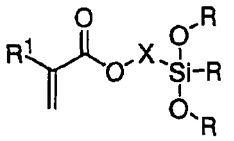

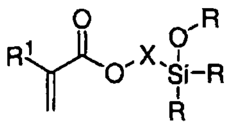

in which in which R is alkyl or aryl; $R^1$ is hydrogen, alkyl, or aryl; and X is an organic moiety and

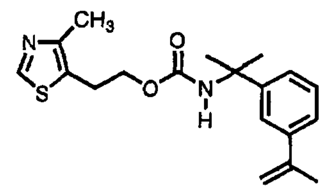

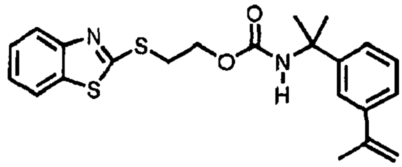

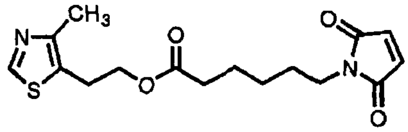

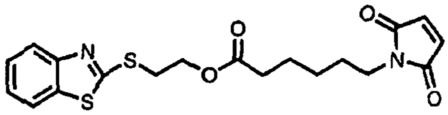

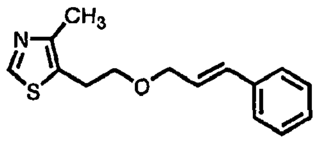

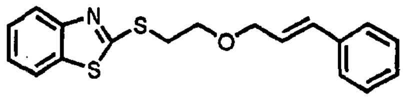

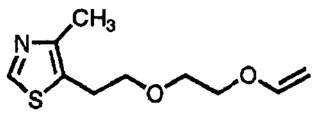

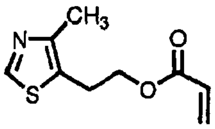

10. The polymer according to claim 1 in which the carbon to carbon double bond is provided by monomers selected from the group consisting of acrylate, methacrylate, fumarate, maleate, maleimide, vinyl ether, allyl ether, acrylamide, styrenic, and cinnamyl compounds.

11. The polymer according to claim 2 in which the polymer is prepared from 3-(tris(trimethylsilyloxy)silyl)-propyl methacrylate, n-butyl acrylate, glycidyl methacrylate, acrylonitrile, and cyanoethyl acrylate.

12. The polymer according to claim 2 in which the polymer is prepared from 3-(tris(trimethylsilyloxy)silyl)-propyl methacrylate, n-butyl acrylate, glycidyl methacrylate, and acrylonitrile.

13. The polymer according to claim 2 in which the polymer is prepared from 3-(tris(trimethylsilyloxy)silyl)-propyl methacrylate, n-butyl acrylate, glycidyl methacrylate, and cyanoethyl acrylate.

14. A curable composition comprising the polymer according to claim 1.

15. The curable composition according to claim 14 further comprising one or more curable resins, or one or more curing agents, or one or more fillers, or any combination of these.

16. An article having deposited thereon a polymer according to any one of claims 1 to 13.

17. An article having deposited thereon a polymer according to any one of claims 1 to 13, which polymer has been heated or irradiated to B-stage.

18. An article having deposited thereon a curable composition according to claim 14 or 15.

19. An article having deposited thereon a curable composition according to claim 14 or claim 15, which curable composition has been heated or irradiated to B-stage.

20. A substrate for a semiconductor wafer or chip, or a semiconductor wafer or chip, having deposited thereon a polymer according to any one of claims 1 to 13.

21. A substrate for a semiconductor wafer or chip, or a semiconductor wafer or chip, having deposited thereon a polymer according to any one of claims 1 to 13, which polymer has been heated or irradiated to B-stage.

22. A substrate for a semiconductor wafer or chip, or a semiconductor wafer or chip, having deposited thereon a curable composition according to claim 14 or 15.

23. A substrate for a semiconductor wafer or chip, or a semiconductor wafer or chip, having deposited thereon a curable composition according to claim 14 or 15, which curable composition has been heated or irradiated to B-stage.

24. A semiconductor package or device, having deposited thereon a polymer according to any one of claims 1 to 13.

25. A semiconductor package or device, having deposited thereon a polymer according to any one of claims 1 to 13,

which polymer has been heated or irradiated to B-stage.

**26.** A semiconductor package or device, having deposited thereon a curable composition according to claim 14 or claim 15.

**27.** A semiconductor package or device, having deposited thereon a curable composition according to claim 14 or claim 15, which curable composition has been heated or irradiated to B-stage.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 6441121 B
- US 6706835 B
- US 6953862 B
- US 6753434 B
- US 6982338 B
- US 20040225074 A1
- US 6441213 B